# EUROPEAN PATENT APPLICATION

(11) **EP 3 211 584 A1**
(43) Date of publication of application: **30.08.2017**
(21) Application number: 14904301.0
(22) Date of filing: 24.10.2014
(51) Int. Cl.: G06Q 50/10, G06F 19/00

(54) **SIMULATION METHOD, SIMULATION PROGRAM, AND SIMULATION DEVICE**

(71) Applicant: Fujitsu Limited, Kawasaki-shi, Kanagawa 211-8588 (JP)
(72) Inventor: OHORI, Kotaro, Kawasaki-shi Kanagawa 211-8588 (JP); ANAI, Hirokazu, Kawasaki-shi Kanagawa 211-8588 (JP); TAKAHASHI, Shingo, Tokyo 169-8050 (JP); HACHIYA, Yuki, Tokyo 169-8050 (JP)
(74) Representative: Hoffmann Eitle
(86) International application number: PCT/JP2014/078416
(87) International publication number: WO 2016/063426

(57) **Abstract**

A movement route is formed in accordance with actual conditions of an intruder. A simulation method, for simulating by using a computer a movement of an intruder that has entered a security zone, that causes the computer to execute a process including generating a model of a movement route by referring to a storage unit that stores information related to a movement route included in the security zone, receiving input of a position to which a security guard is deployed from among positions in the model of the movement route, generating an agent of an intruder at one of the positions in the model of the movement route, and forming a movement route of the agent of the intruder in accordance with the position of the security guard in a case when the security guard is included in an identification scope, in which the agent of the intruder identifies the security guard, when a movement of the generated agent of the intruder is simulated.

## Description

### FIELD

The embodiments discussed herein are related to a simulation method, a simulation program and a simulation apparatus.

### BACKGROUND

Technologies of creating a security plan against offenders who enter particular zones are proposed. For example, a method of creating a security plan by using a mathematical approach in which linear programming, mixed integer programming, etc. are repeated is proposed.

Also, a method of evaluating a security plan created mathematically by using a sensibility analysis with varying parameter values and a method of evaluating a security plan on the basis of the subjectivity of an expert are proposed (see Non Patent Document 1 through Non Patent Document 3 for example).

Among the above security plans, in the method using a mathematical approach a security plan is created and evaluated on an assumption that offenders are reasonable. For example, it is assumed that a reasonable intruder will know all facilities that are security targets on the security-providing side. It is also assumed that a reasonable intruder will move to a target facility by the shortest route.

Accordingly, it is pointed out that evaluation of an appropriate security plan is difficult because offenders are assumed to be reasonable. It is also pointed out that a security plan based on the subjectivity of an expert is based on experimental rules, making it difficult to evaluate an appropriate security plan.

### [Prior Art Document]

### [Patent Documents]

[Non Patent Document 1] M. Jain, D. Korzhyk, O. Vanek, V. Conitzer, M. Pechoucek and M. Tambe, "A double oracle algorithm for zero-sum security games on graphs" (U.S.) In The 10th International Conference on Autonomous Agents and Multiagent Systems - AAMAS '11, pp. 327-334, 2011.
[Non Patent Document 2] M. Jain, V. Conitzer, and M. Tambe "Security Scheduling for Real-world Networks" (U.S.) In The 12th International Conference on Autonomous Agents and Multiagent Systems - AAMAS'13, pp. 215-222, 2013.
[Non Patent Document 3] M.E. Taylor, C. Kiekintveld, C. Western and M. Tambe, "A Framework for Evaluating Deployed Security Systems: Is There a Chink in your ARMOR?" (Slovenia) Informatica, Vol. 34, pp. 129-139, 2010.
[Non Patent Document 4] A.X. Jian, M. Jain, M. Tambe, "Computational game theory for security and sustainability" Journal of Information Processing, Vol. 22, No. 2, pp. 176-185, 2014

### SUMMARY

According to the simulations of the conventional technologies, it is difficult to execute a simulation in accordance with the actual conditions of actions of intruders. It is also difficult to appropriately evaluate a security plan when the evaluation of the security plan is to be made on the basis of a mathematical approach or the subjective perspective of an expert.

It is an object of an aspect of the present invention to form a movement route while taking actual conditions of intruders into consideration. It is an object of another aspect of the present invention to appropriately evaluate a security plan.

One aspect of the present invention is a simulation method, for simulating by using a computer a movement of an intruder that has entered a security zone, that causes the computer to execute a process including generating a model of a movement route by referring to a storage unit that stores information related to a movement route included in the security zone, receiving input of a position to which a security guard is deployed from among positions in the model of the movement route, generating an agent of an intruder at one of the positions in the model of the movement route, and forming a movement route of the agent of the intruder in accordance with the position of the security guard in a case when the security guard is included in an identification scope, in which the agent of the intruder identifies the security guard, when a movement of the generated agent of the intruder is simulated.

One aspect of the present invention makes it possible to form a movement route in accordance with actual conditions of an intruder. Another aspect of the present invention makes it possible to evaluate a security plan appropriately.

### BRIEF DESCRIPTION OF DRAWINGS

FIG. 1 is a functional block diagram illustrating an example of a simulation apparatus;
FIG. 2 illustrates an example of a model;
FIG. 3 illustrates an example of spatial information;
FIG. 4 illustrates an example of security plan information;
FIG. 5 illustrates an example of intruder information;
FIG. 6 is a flowchart illustrating an example of a flow of the process of the embodiment (first);
FIG. 7 is a flowchart illustrating an example of a flow of the process of the embodiment (second);
FIG. 8 illustrates an example of a security guard and an intruder agent in a model (first);
FIG. 9 illustrates an example of a security guard and an intruder agent in a model (second);
FIG. 10 is a flowchart illustrating an example of a flow of the process of the embodiment (third);
FIG. 11 illustrates a simulation in a first specific example (first);
FIG. 12 illustrates the simulation in the first specific example (second);
FIG. 13 illustrates the simulation in the first specific example (third);
FIG. 14 illustrates the simulation in the first specific example (fourth);
FIG. 15 illustrates the simulation in the first specific example (fifth);
FIG. 16 illustrates the simulation in the first specific example (sixth);
FIG. 17 illustrates the simulation in the first specific example (seventh);
FIG. 18 illustrates the simulation in the first specific example (eighth);
FIG. 19 illustrates the simulation in the first specific example (ninth);
FIG. 20 illustrates the simulation in the first specific example (tenth);
FIG. 21 illustrates a simulation in a second specific example (first);
FIG. 22 illustrates the simulation in the second specific example (second);
FIG. 23 illustrates the simulation in the second specific example (third);
FIG. 24 illustrates the simulation in the second specific example (fourth);
FIG. 25 illustrates the simulation in the second specific example (fifth);
FIG. 26 illustrates the simulation in the second specific example (sixth);
FIG. 27 illustrates the simulation in the second specific example (seventh);
FIG. 28 illustrates a simulation in a third specific example (first);
FIG. 29 illustrates the simulation in the third specific example (second);
FIG. 30 illustrates the simulation in the third specific example (third);
FIG. 31 illustrates an example of numerical evaluation (first);
FIG. 32 illustrates an example of numerical evaluation (second); and
FIG. 33 illustrates an example of a hardware configuration of a simulation apparatus.

### DESCRIPTION OF EMBODIMENTS

### <Example of simulation apparatus>

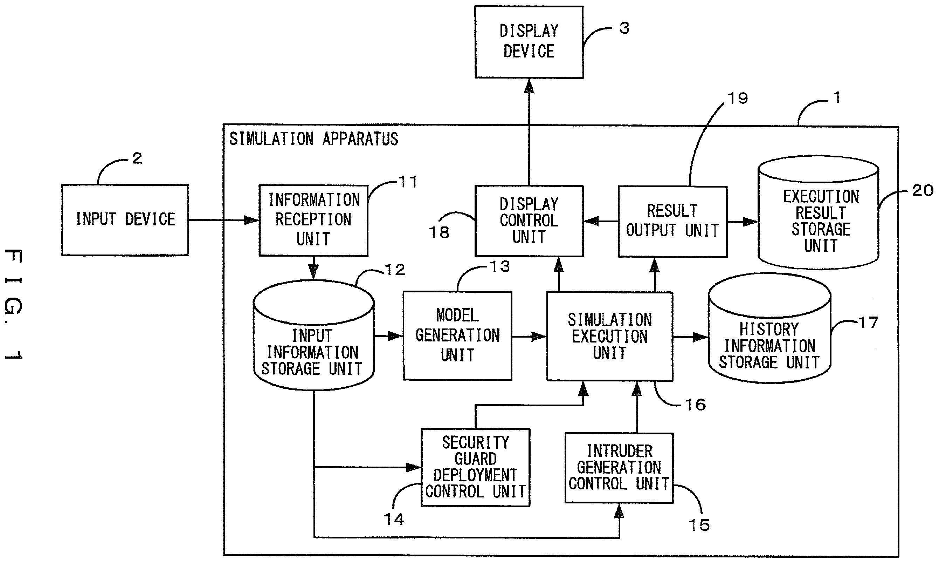

Hereinafter, explanations will be given for the embodiments by referring to the drawings. FIG. 1 illustrates an example of a simulation apparatus 1 that executes a simulation. In the example illustrated in FIG. 1, an input device 2 and a display device 3 are connected to the simulation apparatus 1. The simulation apparatus 1 may be an information processing apparatus that processes prescribed information.

The input device 2 is a device that inputs prescribed information to the simulation apparatus 1. For example, the input device 2 may be a mouse, a keyboard, etc. The display device 3 displays prescribed information under control of the simulation apparatus 1. For example, the display device 3 may be a display device etc. The display device 3 is an example of a display unit.

The simulation apparatus 1 includes an information reception unit 11, an input information storage unit 12, a model generation unit 13, a security guard deployment control unit 14, an intruder generation control unit 15, a simulation execution unit 16, a history information storage unit 17, a display control unit 18, a results output unit 19, and an execution results storage unit 20.

The information reception unit 11 receives prescribed information from the input device 2. Prescribed information received by the information reception unit 11 includes for example model information, security plan information and intruder information. The information reception unit 11 may receive information that is not model information, security plan information or intruder information.

For example, spatial information is information related to the space of a security zone. Spatial information may be information of routes based on information about roads contained in map information obtained by extracting roads and facilities etc. from map information containing information of roads and facilities, etc. in security zones.

Security plan information is for example information related to a security zone that is created in advance. Security plan information may include information on a deployment position of a security guard. Information related to a security method may be information related to a security method that is created in advance in accordance with for example the offense type being planned by the intruder that has entered the security zone.

Intruder information is information related to an intruder in a case when the intruder has entered a security zone. One or a plurality of intruders may enter a security zone. Each intruder has his or her own inherent attributes. Accordingly, intruder information is set for each intruder.

The input information storage unit 12 stores information received by the information reception unit 11. In the above example, the input information storage unit 12 stores spatial information, security plan information and intruder information. The input information storage unit 12 may store information that is not spatial information, security plan information or intruder information. The input information storage unit 12 is an example of a first storage unit or a storage unit.

The model generation unit 13 refers to spatial information stored in the input information storage unit 12 so as to generate a model used when a simulation is executed. Spatial information includes information related to roads etc. A model generated by the model generation unit 13 functions as a model of a movement route based on information of roads etc. This model may also be referred to as a network model.

In the embodiment, the model generation unit 13 treats a route in a security zone as an edge, and generates a model by treating a branching point of the edge as a node. A model may have information that is not an edge or a node. When for example an intruder has a plan to commit an offense in a facility that is neighboring a node, the model generation unit 13 may generate a model that associates the node and the facility.

The security guard deployment control unit 14 refers to security plan information stored in the input information storage unit 12 so as to deploy a security guard in a model of the simulation execution unit 16. The security guard deployment control unit 14 deploys one or a plurality of security guards at an edge of a model. Positions at which security guards are deployed are not limited to edges.

The intruder generation control unit 15 refers to intruder information stored in the input information storage unit 12 so as to make the model of the simulation execution unit 16 cause an agent of one or a plurality of intruders in one of the movement routes of the model to be generated.

In the embodiment, the intruder generation control unit 15 generates an agent of an intruder in a node. A position at which an agent of an intruder is generated is not limited to a node. The intruder generation control unit 15 is an example of an agent generation unit.

The simulation execution unit 16 simulates actions of an agent of an intruder (which will be referred to as an intruder agent hereinafter) in the model generated by the model generation unit 13. Also, the simulation execution unit 16 identifies a movement route when an intruder agent has moved.

The simulation execution unit 16 selects a movement route so as to increase a selection probability that an avoidance route of avoiding the positions of security guards deployed in the model will be selected. Note that in a simulation, an intruder agent may be staying at a prescribed node or edge.

An intruder agent obtains history information while moving in a model. The history information storage unit 17 stores history information for each intruder agent. The history information storage unit 17 is an example of a second storage unit.

History information includes identification information and arrest information. Identification information is information related to a deployment position of a security guard that has been registered by an intruder agent. Arrest information is information related to a position at which a different intruder agent was arrested. A new piece of information may be added to history information as time elapses.

The display control unit 18 displays, on the display device 3, the content of the simulation executed by the simulation execution unit 16. The display control unit 18 displays the movement route of an intruder agent identified by the simulation execution unit 16. The display control unit 18 may display a movement route of an intruder agent in a manner different from those of other movement routes.

The result output unit 19 obtains an execution result of a simulation from the simulation execution unit 16. Then, the result output unit 19 stores the obtained execution result in the execution result storage unit 20. The result output unit 19 also outputs the execution result of the simulation to the display control unit 18.

The execution result storage unit 20 stores the simulation result. A simulation result includes various types of information. For example, a simulation result may include information of the movement route of an intruder agent and the achievement of a goal, or the arrest or the withdrawal of the intruder agent. Also, an execution result of a simulation may include identification information that varies each time an intruder agent moves.

The input information storage unit 12, the history information storage unit 17, and the execution result storage unit 20 may be stored in a single storage device or may be stored in different storage devices respectively. When the above three storage units are stored in a single storage device, the content of each of the three storage units is stored in a different storage area in the storage device.

### <Example of model>

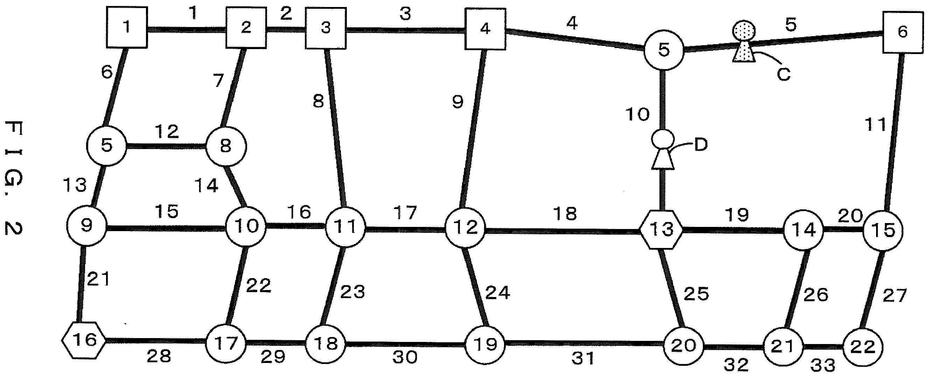

FIG. 2 illustrates an example of a model generated by the model generation unit 13. A model includes an edge and a node. In the embodiment, an edge is a route and a node is a branching point of a route. However, a route is not limited to an edge and a node is not limited to a branching point. In the example of FIG. 2, there are nodes of numbers 1 through 22, and there are edges connecting the nodes, of numbers 1 through 33. A model is not limited to the example illustrated in FIG. 2.

An edge included in a model has a time (movement time) that it takes to move through it. In the case of for example FIG. 2, because edge No. 33 is short, the time that it takes an intruder agent to move through edge No. 33 is short. By contrast, edge No. 9 is long, and thus the time that it takes an intruder agent to move through edge No. 9 is long.

In the example illustrated in FIG. 2, the security guard deployment control unit 14 has deployed security guard D on edge No. 10. Also, the intruder generation control unit 15 has generated intruder agent C on edge No. 5. The simulation execution unit 16 makes intruder agent C act in a model as illustrated as the example of FIG. 2 so as to execute a simulation.

In the example illustrated in FIG. 2, the nodes represented by quadrangles from among the nodes appearing in the example are nodes in which the intruder generation control unit 15 generates intruder agents (which will be referred to as a generation node hereinafter). In the example illustrated in FIG. 2, the nodes of numbers 1, 2, 3, 4 and 6 are generation nodes. Because a generation node is a node in which an intruder is generated, the intruder generation control unit 15 for example may determine a generation node on the basis of a geographical condition.

In the example illustrated in FIG. 2, the nodes represented by hexagons from among the nodes appearing in the example are targets of intruder agent C (which will be referred to as a target node herein after). In the example illustrated in FIG. 2, nodes of numbers 13 and 16 are target nodes. The simulation execution unit 16 makes intruder agent C move toward a target node.

When for example intruder agent C has a plan to attack a facility near the target node No. 16, the simulation execution unit 16 makes intruder agent C move toward target node No. 16. Examples of facilities are airports, stations, etc.

In a case when the target node is the node of number 16, when the intruder agent has reached node No. 16, the goal of the intruder agent is achieved. In such a case, the result is that the attack on the facility succeeded and the security plan failed. When by contrast the intruder agent is arrested by a security guard, the attack on the facility fails. Accordingly, the result is that the security plan succeeded.

In the example illustrated in FIG. 2, the nodes represented by the circles from among the nodes appearing in the example are branching points between edges. When intruder agent C has reached a node, the simulation execution unit 16 performs route selection of intruder agent C.

### <Example of spatial information>

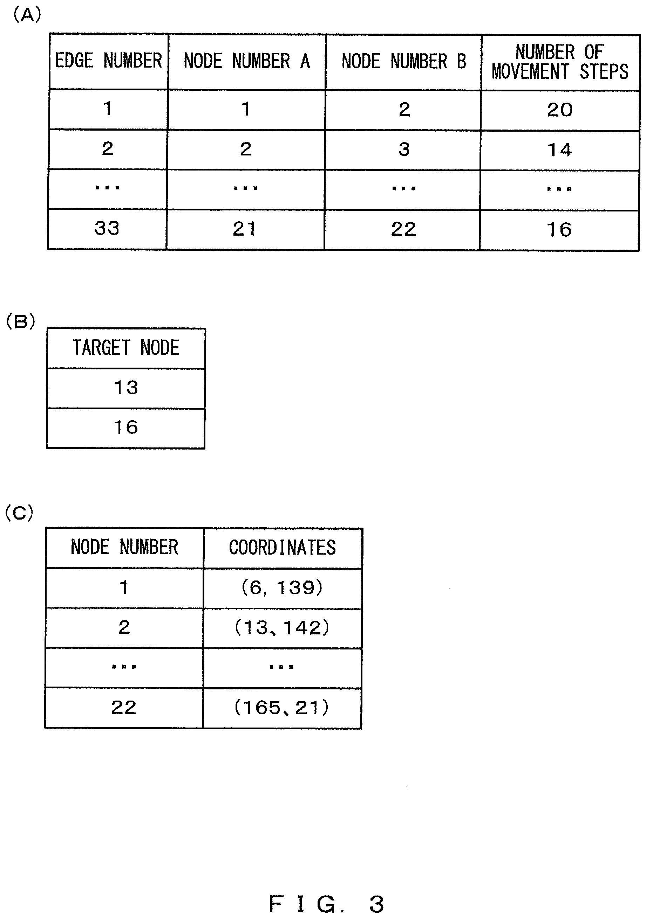

FIG. 3 illustrates an example of spatial information. The example of FIG. 3(A) illustrates a relationship between edge numbers, node number A, node number B and movement steps. An edge identified by an edge number is an edge that connects a node identified by node number A and a node identified by node number B. For example, in the example illustrated in FIG. 3(A), it is illustrated that the edge with edge number 1 is an edge that connects node No. 1 and node No. 2.

A movement step represents the above movement time of an intruder agent in terms of the number of steps. In the example illustrated in FIG. 3(A), it is illustrated that the edge with edge number 1 has 20 as the number of the movement steps. It is also illustrated that the edge with edge number 2 has 14 as the number of movement steps.

This means that the edge with edge number 1 is shorter than the edge with edge number 2. In the embodiment, a model includes 33 edges, and thus spatial information includes information associating the 33 edges and the number of movement steps.

Spatial information includes information of a target node. In the embodiment, the target nodes have numbers 13 and 16. The fact that the target nodes have numbers 13 and 16 is based on information received by the information reception unit 11. When for example an attack target facility is near target nodes No. 13 and No. 16, the target nodes are set to have numbers 13 and 16.

In the embodiment, 22 nodes are set in a model. Each node is set by an XY coordinate system. In the example illustrated in FIG. 3(C), XY coordinates corresponding to the node numbers are defined. Methods of defining nodes or edges are not limited to the one based on an XY coordinate system.

### <Example of security plan information>

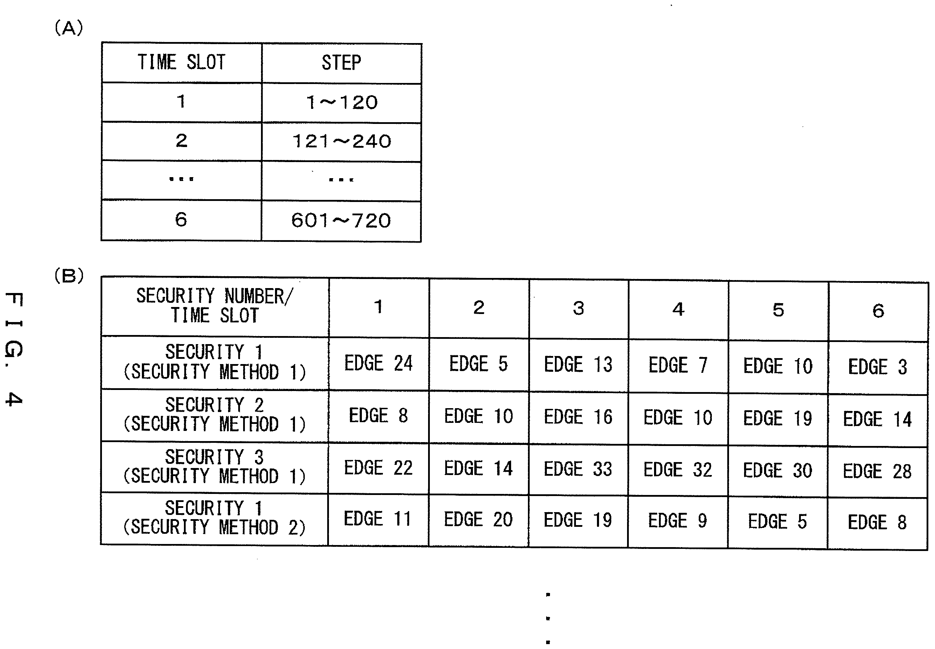

Next, explanations will be given for an example of security plan information by referring to FIG. 4. The example illustrated in FIG. 4(A) illustrates a relationship between time slots and steps. In the example illustrated in FIG. 4(A), one time slot is allocated to each 120 steps.

While the example illustrated in FIG. 4(A) illustrates time slots 1 through 6, the number of time slots is not limited to 6. Also, the number of steps allocated to one time slot is not limited to 120.

The example illustrated in FIG. 4(B) illustrates a security plan. A security plan includes information related to the deployment of security guards that is created in advance. The columns in FIG. 4(B) store security numbers in a security method. A security method is a method of a security plan created in accordance with the offense type. The number of the offense type planned by an intruder is not limited to 1. In some cases, intruders have plans for a plurality of types of offenses.

For example, an intruder may have a plan to destroy a facility and another intruder may have a plan to spread a hazardous material in a facility. Further, still another intruder may plan transactions of hazardous materials in a facility.

Thus, each intruder may have a plan for a different offense type. A security plan is created in accordance with the offense type. It is assumed for example that security method 1 illustrated in FIG. 4(B) is a security plan against an intruder having a plan to destroy a facility. It is also assumed that security method 2 is a security plan against an intruder having a plan to spread a hazardous material in a facility.

While FIG. 4(B) illustrates the security methods of numbers 1 and 2, there may be a security method of number 3 or a greater number. For example, security method 3 may be a security plan against an intruder planning transactions of hazardous materials in a facility.

There are resources of security guards that are allocated to one security method. For example, in the example illustrated in FIG. 4(B), resources with the security numbers 1 through 3 are allocated to security method 1. In FIG. 4(B), security numbers 1 through 3 appear as "security 1", "security 2" and "security 3", respectively.

Thus, in the case of security method 1, three locations in the model are the targets of the security. The number of the security guards securing the security positions identified by security numbers may be one or may be plural. For some types of offenses, the security guard deployment control unit 14 may deploy a plurality of security guards for the security for one location. In the embodiment, it is assumed that the security guard deployment control unit 14 deploys one security guard for the security for one location.

In the embodiment, a position at which each security number provides security varies depending upon the time slots. It is assumed for example that when the security number is 1 and the time slot is 1, the security guard deployment control unit 14 deploys a security guard to edge No. 24.

When the time slot is 2, the security guard deployment control unit 14 changes the deployment position of the security guard from number 24 to number 5. Note that the security guard deployment control unit 14 may always deploy a security guard to the same position in a fixed manner regardless of the time slots.

### <Example of intruder information>

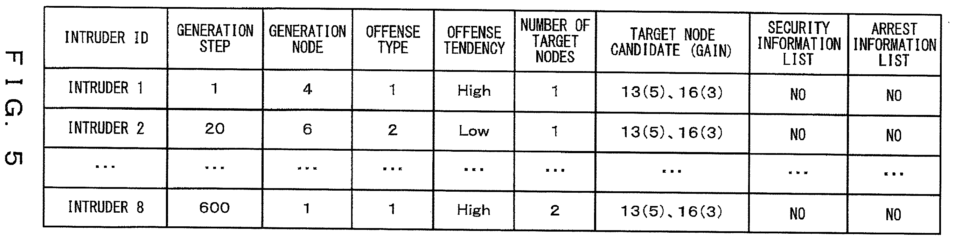

Next, an example of intruder information will be explained by referring to FIG. 5. In the example illustrated in FIG. 5, the intruder information includes the items for intruder ID, generation step, generation node, offense type, offense tendency, number of target nodes, facility, security information list and arrest information list.

An intruder ID (ID is an abbreviation for identification) is an identifier for identifying an intruder agent. In the example illustrated in FIG. 5, intruder information includes numbers 1 through 8 as intruder IDs. A generation step represents the number of steps of an intruder generated in a model for each intruder. A period with short intervals between generation steps is a period with a high generation frequency.

A generation node represents a node number of a node in which an intruder is generated for each intruder. An offense tendency represents a tendency related to an offense for each intruder. An offense tendency is also referred to as a risk preference. An intruder with a "high" offense tendency will try to succeed in the offense that he or she has planned, even by taking risks. By contrast, an intruder with "low" offense tendency will tend to avoid risk.

The number of target nodes represents the number of the above target nodes for each intruder. The number of target nodes represents a criterion for determining whether the intruder will terminate the action. For example, when an intruder agent with a number of nodes of 1 reaches a target node, the action of the intruder agent will be terminated.

Even when by contrast an intruder agent with a number of target nodes of 2 reaches the first target node, the action of the intruder agent will not be terminated because the number of the target nodes is 2. In such a case, the simulation execution unit 16 makes the intruder agent move toward the next target node.

A target node candidate represents a candidate for a target node for each intruder. In the example illustrated in FIG. 5, the nodes with node numbers 13 and 16 are candidates for target nodes. As illustrated in the example of FIG. 5, a gain is associated with a target node candidate. A gain is a point obtained when an intruder agent reaches a target node candidate.

A security information list is an example of identification information. A security information list of the embodiment is a list containing information of a deployment position of a security guard identified by an intruder agent. The simulation execution unit 16 may add new information related to a deployment position of a security guard to a security information list in response to moving an intruder agent.

An arrest information list is an example of arrest information. When a different intruder agent is generated in a model and that different intruder agent is arrested, the simulation execution unit 16 adds, to the arrest information list, information of the position at which the different intruder was arrested.

### <Example of a flow of processes of embodiment>

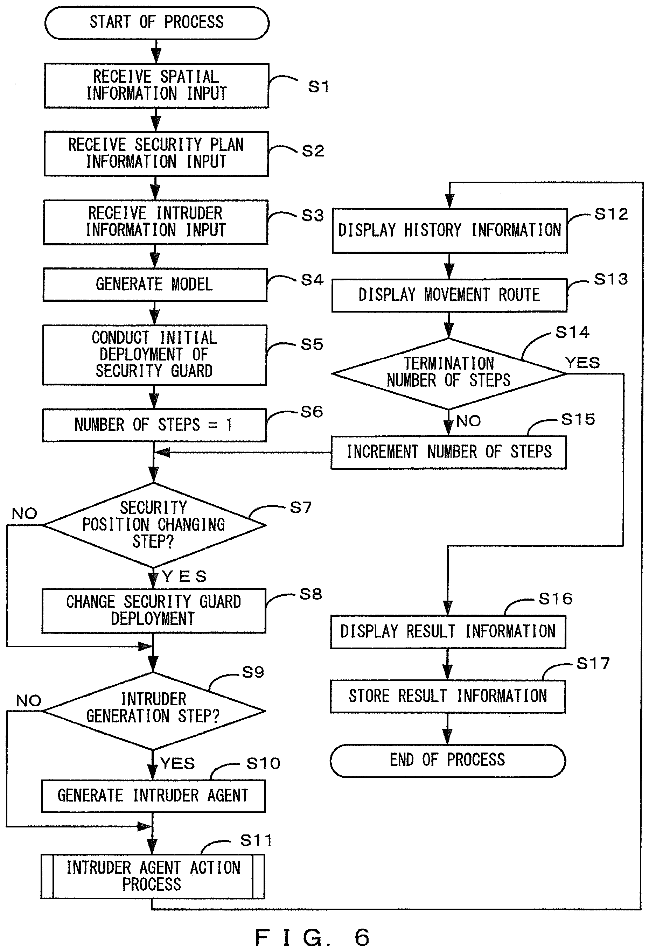

Next, explanations will be given for a flow of processes in the embodiment by referring to FIG. 6. The information reception unit 11 receives input of spatial information (step S1). Spatial information is information on which a model of a security zone is based and includes information related to routes in the security zone. Spatial information may be for example information based on map information.

Also, the information reception unit 11 receives input of security plan information (step S2). Security plan information includes information for deploying a security guard in a model. While a security guard is deployed at an edge in a model in the embodiment, a security guard may be deployed to a position that is not at an edge.

Also, the information reception unit 11 receives input of intruder information (step S3). The information reception unit 11 stores, in the input information storage unit 12, the spatial information, the security plan information and the intruder information that were input to the information reception unit 11.

The model generation unit 13 generates, on the basis of spatial information, a model of a movement route to be executed by the simulation execution unit 16 (step S4). In the embodiment, a model includes an edge and a node. A model may be represented by a movement route that is not an edge or a node.

A target for an intruder agent is a prescribed point or zone in a model. When an intruder agent moves through a movement route to reach a prescribed point, the simulation execution unit 16 may assume that a goal of the intruder agent has been achieved. When a target is a zone, and an intruder agent has entered the zone, the simulation execution unit 16 may assume that a goal of the intruder agent has been achieved. In the embodiment, a target for an intruder agent is a target node.

A model generated by the model generation unit 13 is output to the simulation execution unit 16. The security guard deployment control unit 14 initially deploys a security guard in a model of the simulation execution unit 16 on the basis of security plan information stored in the input information storage unit 12. The security guard deployment control unit 14 initially deploys a security guard in a model for each security method.

The simulation execution unit 16 counts the steps. The simulation execution unit 16, when starting the execution of a simulation, sets the number of steps to 1 (step S6). This number of steps is incremented by the simulation execution unit 16 each time a prescribed period elapses. The increment of the number of steps will be described later.

The simulation execution unit 16 determines whether or not the number of steps that it is counting has reached the number of steps at which security positions are to be changed (step S7) . In the embodiment, the security guard changes the security position for each time slot.

Accordingly, the simulation execution unit 16, when the number of steps that it is counting has reached the number of steps at which the security position of a security guard is to be changed (YES in step S7), changes the position of a security guard in the model (step S8).

The simulation execution unit 16, when the number of steps that it is counting has not reached the number of steps at which the security position of a security guard is to be changed (NO in step S7), does not perform the process in step S8.

The simulation execution unit 16 determines whether or not the number of steps that it is counting is a generation step of an intruder agent (step S9). Intruder information includes information of a generation step for each intruder agent.

Accordingly, when the current number of steps has reached the generation step of any one of the intruder agents in intruder information (YES in step S9), the intruder generation control unit 15 generates an intruder agent in a model of the simulation execution unit 16 (step S10).

When the above intruder information includes a plurality of target node candidates, the intruder generation control unit 15 selects a target node from among the plurality of target node candidates. For example, the intruder generation control unit 15 may select one target node at random from among a plurality of target node candidates.

Also, a gain is associated with a target node candidate. Accordingly, the intruder generation control unit 15 may select a target node stochastically on the basis of gains. For example, in the example illustrated in FIG. 5, the target node candidates with the intruder ID 1 are numbers 13 and 16.

The gain of number 13 as the target node candidate is 5 and the gain of number 16 as the target node candidate is 3. Accordingly, the intruder generation control unit 15 may select the node of number 13 as a target node with a probability of 5/8 and may select the node of number 16 as a target node with a probability of 3/8.

When the current number of steps has reached the generation step of neither piece of the intruder information (NO in step S9), the intruder generation control unit 15 does not execute the process in step S10.

The simulation execution unit 16 moves an intruder agent in the model (step S11). The simulation execution unit 16 selects a movement route of an intruder as an avoidance route so as to increase a probability that the deployment position of a security guard is avoided. The movement of an intruder agent will be described later.

The simulation execution unit 16 controls the display control unit 18 so that history information is displayed including identification information and arrest information in association with an intruder agent in the model. The display control unit 18 displays history information in the display device 3 in association with an intruder agent (step S12).

The simulation execution unit 16 forms a movement route of an intruder agent. The display control unit 18 displays the formed movement route of an intruder agent in the display device 3 (step S13).

In the simulation execution unit 16, a step of terminating a simulation (which will be referred to as the termination number of steps) is set in advance. An arbitrary number is set as this termination number of steps in the simulation execution unit 16.

The simulation execution unit 16 determines whether or not the number of steps that it is counting has reached the termination number of steps (step S14). When the termination number of steps has not been reached (NO in step S14), the simulation execution unit 16 increments the number of steps that it is counting (step S15).

Then, the process returns to step S7. Accordingly, the simulation execution unit 16 repeats the process from step S7 through step S13 until the number of steps that it is counting reaches the termination number of steps. In other words, the simulation execution unit 16 continues the execution of a simulation until the termination number of steps is reached.

When the number of steps that the simulation execution unit 16 is counting has reached the termination number of steps (YES in step S14), the display control unit 18 displays the execution result in the display device 3 (step S16).

An execution result is information related to the result of the execution of a simulation by the simulation execution unit 16. An execution result may include not only information of the result of the execution of a simulation but also information such as spatial information, security plan information, intruder information, etc.

The result output unit 19 obtains an execution result from the simulation execution unit 16. Then, the result output unit 19 stores the obtained execution result in the execution result storage unit 20. Also, the result output unit 19 outputs the execution result to the display control unit 18, and the display control unit 18 displays the execution result in the display device 3.

The result output unit 19 may store, in the execution result storage unit 20, the execution result of each step from the simulation execution unit 16. Execution results stored in the execution result storage unit 20 may be output as a log.

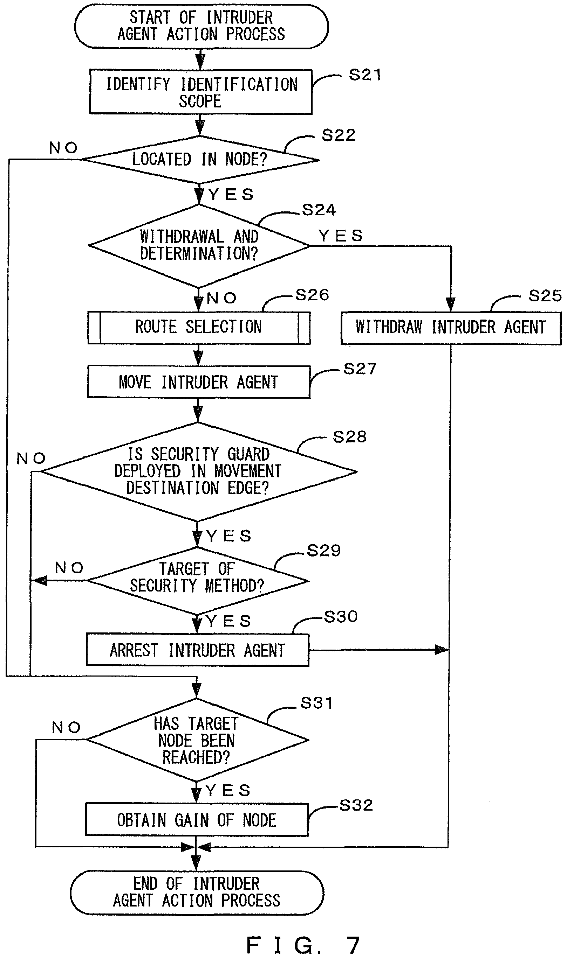

Next, explanations will be given for the intruder agent action process in step S11 by referring to the flowchart illustrated in FIG. 7. The simulation execution unit 16 makes an intruder agent identify an identification scope in accordance with the current position (step S21). When there are a plurality of intruder agents, the simulation execution unit 16 makes each intruder agent identify an identification scope in accordance with the current position.

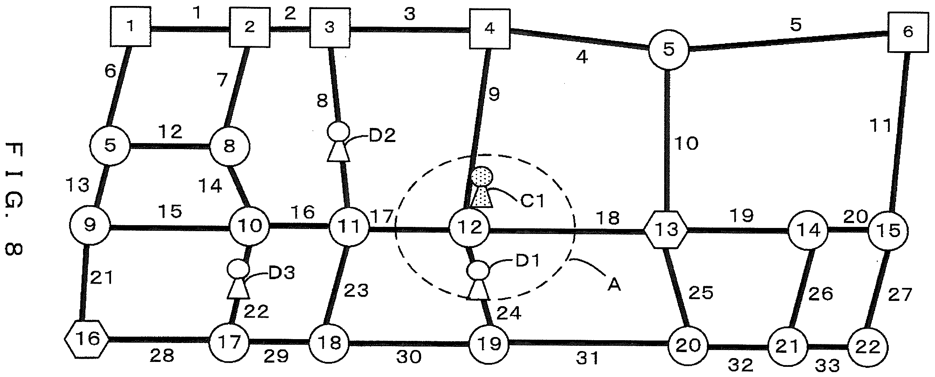

Explanations will be given for an identification scope. FIG. 8 illustrates examples of security guards D1 through D3 deployed in the model and intruder agent C1 that moves in the model. Security guard D1 has been deployed on edge No. 24. Security guard D2 has been deployed on edge No. 8. Security guard D3 has been deployed on edge No. 22. Intruder agent C1 has reached node No. 12.

An identification scope is a scope in which an intruder agent can identify a security guard in accordance with the position in a model. The identification scope varies depending upon the positions in a model. For example, with respect to a curved route, the scope in which intruder agent C1 can identify a security guard is narrow. A case where a route has an obstacle etc. also results in a narrow scope in which intruder agent C1 can identify a security guard.

The scope in which intruder agent C1 at a position on a straight route can identify a security guard is wide. A case where a route has no obstacles etc. also results in a wide scope in which intruder agent C1 can identify a security guard. For example, depending upon the position of a node, a wide area including a plurality of nodes and edges with that node at the center may be an identification scope.

In the example illustrated in FIG. 8, identification scope A, in which intruder agent C1 identifies a security guard, is represented by a dashed line. Node No. 12, in which intruder agent C1 exists, has relatively wide identification scope A. Thus, intruder agent C1 can identify security guard D1 in identification scope A.

When a security guard is in identification scope A of intruder agent C1, the simulation execution unit 16 adds, to a security information list, identification information related to the position of the identified security guard. In the case of the example illustrated in FIG. 8, because security guard D1 is on edge No. 24, the simulation execution unit 16 adds edge No. 24 to the security information list.

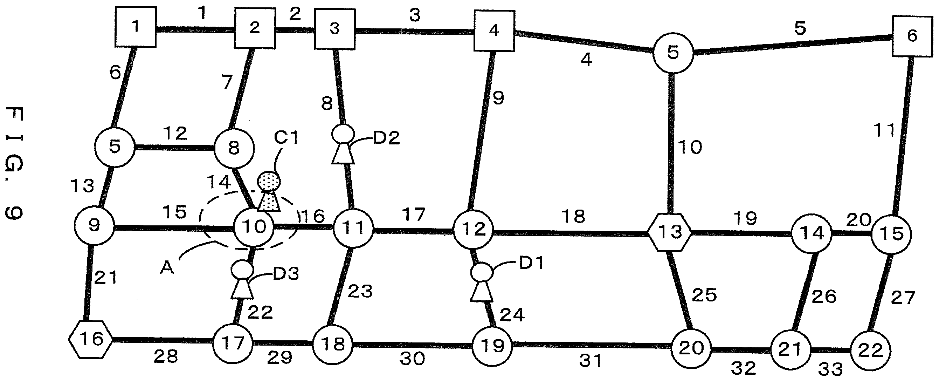

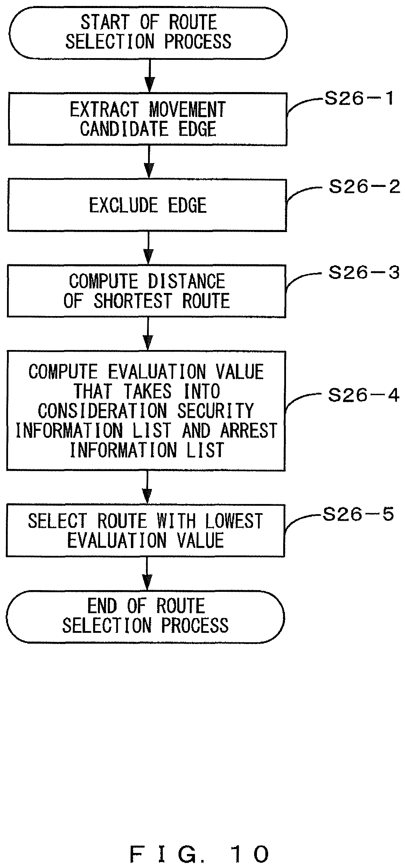

FIG. 9 illustrates an example in which intruder agent C1 is in node No. 10. In the example illustrated in FIG. 10, it is assumed that identification scope A in node No. 10 is narrow for, among others, a reason for example that the route is curved. In such a case, the distance between intruder agent C1 and security guard D3 is short. However, because security guard D3 is not included in the identification scope of node No. 10, intruder agent C1 does not identify security guard D3.

In the embodiment, after reaching a node, an intruder agent decides the next route to move through, i.e., an edge. For the decision, identification scope A of the node serves as a factor for an intruder agent to decide which route to select next.

Accordingly, in the embodiment, identification scope A is set for each of node No. 1 through node No. 22. However, an edge instead of a node may have identification scope A. Identification scope A may be set for each position of a route in a model.

The above are the explanations related to an identification scope in step S21 in FIG. 7. After an intruder agent identifies the identification scope of the current position in the model, the simulation execution unit 16 determines whether or not the intruder agent is located in a node.

When an intruder agent is in a node (YES in step S22), the simulation execution unit 16 determines which of the edges the intruder agent is to move to next. An intruder agent may take an action of withdrawal. Withdrawal means a situation where an intruder agent leaves a security zone. The simulation execution unit 16 determines whether or not an intruder agent will withdraw (step S24).

When the intruder agent will withdraw (YES in step S24), the simulation execution unit 16 makes the intruder agent withdraw (step S25). In such a case, the intruder agent disappears from the model. When the intruder agent will not withdraw (NO in step S24), the simulation execution unit 16 selects the next route for the intruder agent (step S26).

Explanations will be given for the determination of route selection and withdrawal. First, explanations will be given for route selection by referring to the flowchart illustrated in FIG. 10. There are a plurality of routes for an intruder agent in a node to use to reach a target node. A plurality of edges and nodes existing between the node in which the intruder agent is and a target node leads to a greater number of routes from which the route selection is made.

The simulation execution unit 16 extracts a node to which the intruder agent can move to from the node having the intruder agent (step S26-1). The edge extracted by the simulation execution unit 16 will be referred to as a movement candidate edge. A movement candidate edge is an edge connected to a node having an intruder agent.

The simulation execution unit 16 excludes, from movement candidate edges, an edge that an intruder agent passed through immediately before and an edge included in a security information list (stepS26-2). Because an edge that an intruder agent passed through immediately before is an edge that the intruder agent has already passed through, it is excluded from movement candidates.

Also, because there is a high probability that an edge included in a security information list will have an intruder agent arrested on it, it is excluded from movement candidates. Thereby, a probability that an intruder agent will avoid being arrested increases. Note that the simulation execution unit 16 may exclude, from movement candidate edges, an edge included in an arrest information list.

In other words, the simulation execution unit 16 excludes a movement route by which an intruder agent may be arrested, on the basis of history information including identification information and history information. An excluded movement route is an avoidance route resulting in a higher probability that the intruder agent will avoid security guards D1 through D3. Thereby, the simulation execution unit 16 can increase a selection probability of an avoidance route as a movement route.

An increased selection probability of an avoidance route increases a probability that an intruder agent will reach a target node. Because an intruder that has entered a security zone selects a route by which he or she can avoid security guards, a simulation can be executed in accordance with the actual conditions.

The simulation execution unit 16 evaluates the shortest route from among all routes that are connected to a target node via the movement candidate edges from which the above edge was excluded. For this, the simulation execution unit 16 computes an evaluation value.

An evaluation value is a value serving as an index for selecting a route when the simulation execution unit 16 moves an intruder agent. An evaluation value is obtained by correcting a reference evaluation value.

The simulation execution unit 16 obtains the shortest route from among all routes that are connected to a target node via the movement candidate edges. As a method of obtaining a shortest route, Dijkstra's algorithm for example may be used.

The simulation execution unit 16 computes the distance (length) of the shortest route (step S26-3) and treats the computed distance as a reference evaluation value. The simulation execution unit 16 uses the formula below so as to correct the reference evaluation value, and thereby computes an evaluation value (step S26-4).
Evaluation value = reference evaluation value + W1 × (sum of the number of security times identified in the security information lists in the edges included in the shortest route) + W2 × (sum of the number of security times identified in the arrest information lists in the edges included in the shortest route)

Note that W1 and W2 are prescribed coefficients. For example, when the number of security times identified by the security information lists and the arrest information lists included in the shortest route is zero, the evaluation value is equal to the reference evaluation value. Similarly, when W1 and W2 are zero as well, the evaluation value is equal to the reference evaluation value. Accordingly, the intruder agent passes through the shortest route so as to reach a target node.

Meanwhile, the greater the number of security times in the security information lists and the arrest information lists included in the shortest route becomes, the higher the evaluation value becomes. As the evaluation value becomes greater, the probability that the intruder agent will be arrested becomes higher.

The simulation execution unit 16 computes the evaluation value of each route by using the above formula. Then, the simulation execution unit 16 selects a route with a low evaluation value from among all routes that are connected to a target node via the movement candidate edges (step S26-5). This selection is the route selection in step S26.

In the above formula, W1 and W2 are coefficients based on the tendency of an intruder agent. When the tendency of an intruder agent is High (i.e., when the intruder agent has a tendency to achieve a goal even by taking risks), W1 and W2 have lower values.

In such a case, even when the value of the number of security times is high, the evaluation value is low. When the tendency of an intruder agent is Low (i.e., when the intruder agent has a tendency to avoid risks), W1 and W2 have high values, leading to a high evaluation value.

Accordingly, the simulation execution unit 16 computes an evaluation value on the basis of the movement time of each of the plurality of movement routes to a target node and the tendency of the intruder agent. Then, the simulation execution unit 16 selects a route on the basis of the evaluation value. The selection of a route of an intruder agent made by the simulation execution unit 16 is not limited to the above example and an arbitrary method may be used.

Next, explanations will be given for the determination of withdrawal. A withdrawal threshold is set in the simulation execution unit 16 in advance. A withdrawal threshold serves as a threshold for determining whether or not an intruder agent will withdraw. The simulation execution unit 16 compares the computed evaluation value and the withdrawal threshold, and when the evaluation value exceeds the withdrawal threshold, it determines that withdrawal will occur. Thereby, the intruder agent withdraws from the model so as to disappear.

A withdrawal threshold is set for each intruder agent. A withdrawal threshold may be set for a tendency of each intruder agent. An intruder agent having a High tendency tends to achieve a goal even by taking risks, resulting in a high withdrawal threshold. An intruder agent having a Low tendency tends to avoid risks, resulting in a low withdrawal threshold.

As described above, simulation execution unit 16 determines the action of an intruder agent. The simulation execution unit 16, when determining that withdrawal of an intruder agent will occur, makes the intruder agent disappear. In such a case, the action of the intruder agent is terminated.

Accordingly, the intruder agent has withdrawn, which means that he or she failed to achieve the goal and was not arrested. In such a case, the simulation execution unit 16 identifies that the intruder agent has left the security zone.

Next, the processes in and after step S27 illustrated in FIG. 7 will be explained. After selecting a movement route of an intruder agent, the simulation execution unit 16 moves the intruder agent toward the selected movement route (step S27).

The simulation execution unit 16 determines whether or not a security guard has been deployed to the edge to which the intruder agent has moved (step S28) . When a security guard has been deployed to the edge to which the intruder agent has moved (YES in step S28), the simulation execution unit 16 determines whether or not the intruder is a target for the security method (step S29).

As described above, a security plan created in advance may include a plurality of security methods. In the embodiment, a security method is set in accordance with the offense type. It is assumed for example that security method 1 is a security plan against an intruder having a plan to destroy a facility as described above.

This security method 1 is not a security plan against an intruder agent having a plan to spread a hazardous material. In such a case, the simulation execution unit 16 determines that the intruder agent is not a target for the security method (NO in step S29).

It is also possible to employ for example a configuration in which when the number of the security method illustrated in FIG. 4 (B) is identical to the number of the type of the offense illustrated in FIG. 5, the simulation execution unit 16 determines that the intruder is a target for the security method, and when they are not identical, the intruder is determined to not be a target for the security method.

When an intruder agent is determined to be a target for the security method (YES in step S29), the intruder agent will encounter a security guard in a security target, and thus the intruder agent will be arrested (step S30). In such a case, the simulation execution unit 16 make the arrested intruder agent disappear.

When the determination result is NO in step S28 and when the determination result is NO in step S29, the intruder agent will not be arrested. In such a case, the simulation execution unit 16 moves the intruder agent to the next node via the selected route (edge).

The simulation execution unit 16 determines whether or not the node to which the intruder agent has moved is a target node (step S31). When the node to which the intruder agent has moved is a target node (YES in step S31), the intruder agent obtains a gain (step S32).

In such a case, the intruder agent has reached a target node, which means that a goal has been achieved. When the number of the target nodes for an intruder agent is 1, the simulation execution unit 16 makes the intruder agent disappear. When the number of the target nodes for an intruder agent is 2 or greater, the simulation execution unit 16 does not make the intruder agent disappear but moves the intruder agent toward the next target node.

In the above process, the intruder agent action process in step S11 is terminated. The simulation execution unit 16 continues the above simulation until the termination number of steps in step S14 is reached.

Accordingly, in the embodiment, the simulation execution unit 16 executes a simulation of selecting a movement route of an intruder agent on the basis of whether or not a security guard is included in an identification scope in which the intruder agent identifies a security guard.

The actual intruder will also select a route to avoid a security guard when he or she identified a security guard, thus a simulation of a security plan against an intruder can be executed on the basis of the actual conditions. Also, the simulation execution unit 16 selects an avoidance route to avoid the position of a security guard in an identification scope. Accordingly, a simulation based to a greater extent on the actual conditions can be executed.

In addition to the position of a security guard, the simulation execution unit 16 selects an avoidance route to avoid the position at which a different intruder agent was arrested. This makes it possible for an intruder agent to obtain information that increases an avoidance probability, leading to a higher probability that the intruder agent will avoid a security guard. This makes it possible to execute a simulation based to a greater extent on the actual conditions.

### <First specific example>

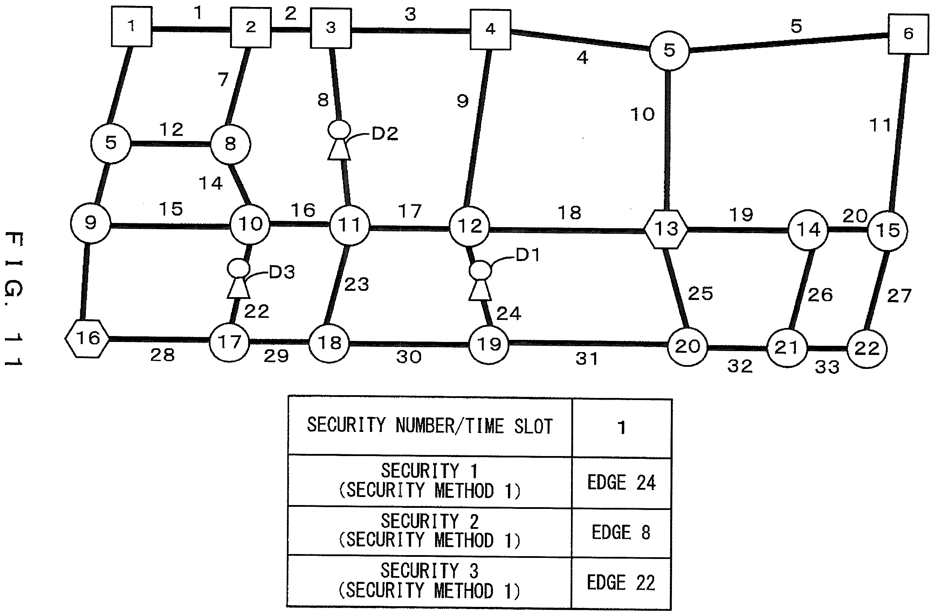

Next, explanations will be given for a first specific example by referring to FIG. 11 through FIG. 20. FIG. 11 illustrates an example of a simulation window in a case when security guards D1, D2 and D3 have been deployed to a model generated by the model generation unit 13. This simulation window is displayed in the display device 3.

The model generation unit 13 generates a model of a security zone on the basis of spatial information stored in the input information storage unit 12. The security guard deployment control unit 14 deploys a security guard to the model by the simulation execution unit 16 on the basis of security plan information.

In the first specific example, the simulation execution unit 16 executes a simulation of security method 1. As illustrated in the example of FIG. 11, security method 1 in time slot 1 is edge 24. Accordingly, the security guard deployment control unit 14 deploys security guard D1 to edge 24. Similarly, the security guard deployment control unit 14 deploys security guard D2 to edge 8 and deploys security guard D3 to edge 22.

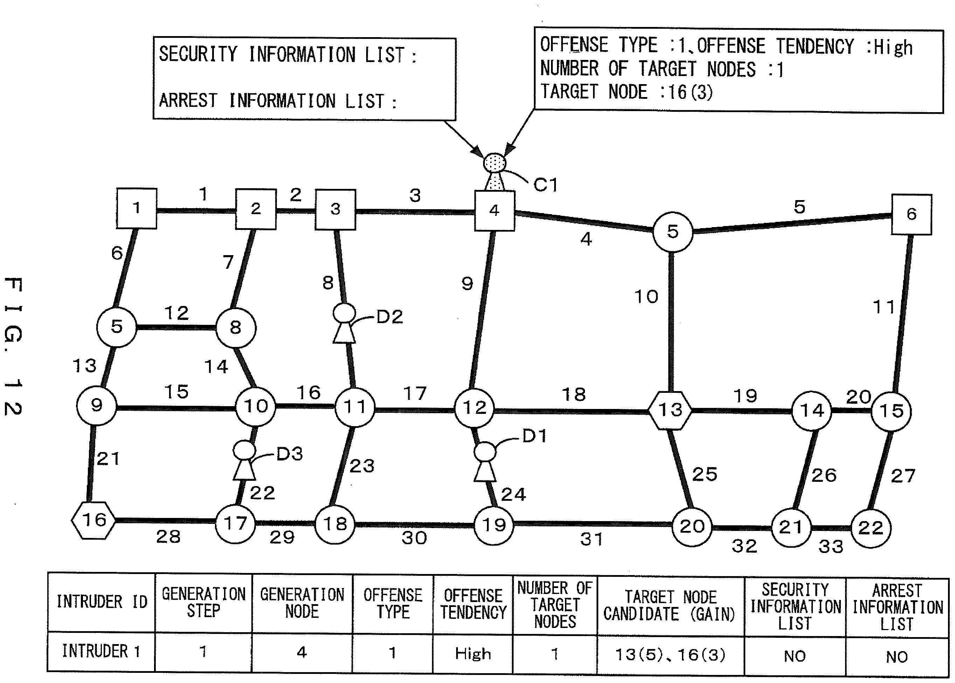

The example in FIG. 12 illustrates a case where the intruder generation control unit 15 generated intruder agent C1 in a model by the simulation execution unit 16. The intruder generation control unit 15 generates intruder agent C1 in node No. 4 on the basis of the intruder information of the intruder with an intruder ID of 1 in the example of FIG. 12.

In the case of the intruder information illustrated in FIG. 12, the target node candidates are node No. 13 and node No. 16. It is assumed that intruder agent C1 has selected node No. 16 as a target node from the two nodes even though the probability is low based on the gain (3/8). Note that because the number of the target nodes is 1, when intruder agent C1 reaches target node No. 16, the goal has been achieved.

As illustrated in the example of FIG. 12, the display control unit 18 displays intruder agent C1 in association with the history information and the attribute information. History information includes a security information list and arrest information list as described above. Attribute information includes the offense type, the offense tendency, the number of target nodes, and information of target nodes.

When intruder agent C1 was generated in node No. 4, no information is included in the history information of intruder agent C1. The simulation execution unit 16 extracts numbers 3, 4 and 9 as the movement candidate edges. Intruder agent C1 has not moved yet and no information is included in the history information.

Accordingly, the simulation execution unit 16 selects an edge for moving to target node No. 16 for each of edge No. 3, edge No. 4 and edge No.9. Because no information is included in the history information of intruder agent C1, the simulation execution unit 16 selects the edge of the shortest route connected to a target node. At that moment, the evaluation value has become equal to the reference evaluation value.

It is assumed that the edge selected by the simulation execution unit 16 is number 9. It is also assumed that the movement number of steps of edge No. 9 is 19. Also, a time that it takes intruder agent C1 to move to one edge will be referred to as a movement number of steps.

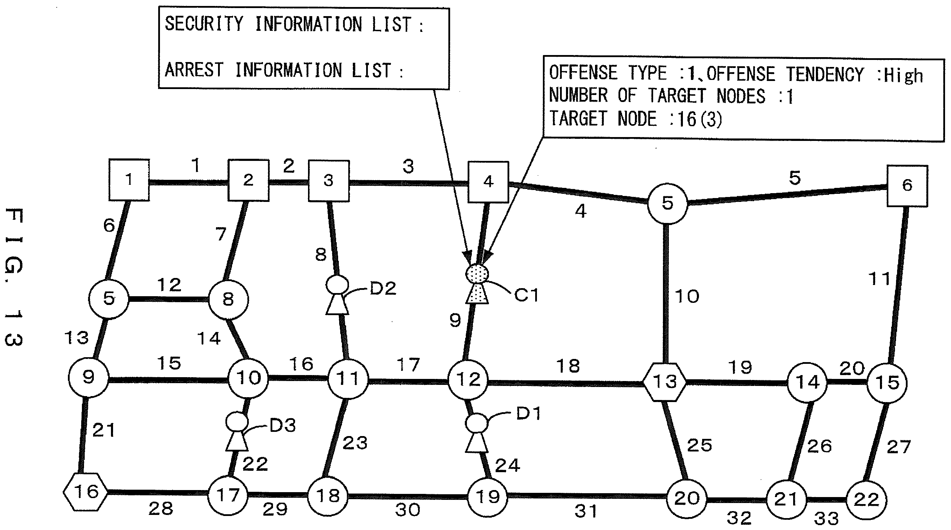

As illustrated in the example of FIG. 13, the simulation execution unit 16 makes intruder agent C1 stay on edge 9 while the number of steps is in a range between 2 and 21. The display device 3 displays a simulation window in which intruder agent C1 is staying on edge 9.

The simulation execution unit 16 increments the number of steps. When the number of steps is 22, the simulation execution unit 16 moves intruder agent C1 to node No. 12.

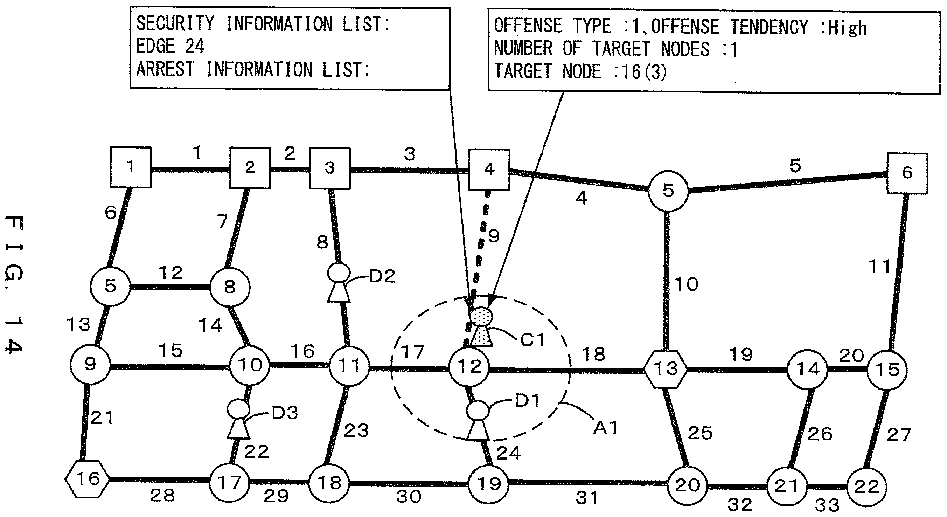

FIG. 14 illustrates a case where intruder agent C1 is in node No. 12. The display control unit 18 displays the movement route of intruder agent C1 (edge No. 9) in a manner different from those of other edges. In the example of FIG. 14, the movement route of intruder agent C1 is represented by a dashed line.

The simulation execution unit 16 determines whether or not a security guard is included in the identification scope of intruder agent C1 located in node No. 12. In the example of FIG. 14, it is assumed that security guard D1 is included in identification scope A1 of intruder agent C1. In such a case, the simulation execution unit 16 adds edge 24 to the security information list of the history information.

The simulation execution unit 16 selects the next movement route of intruder agent C1. The movement candidate edges are the edges of numbers 9, 17 and 24. Edge No. 9 is the edge that the intruder passed through immediately before. Accordingly, the simulation execution unit 16 excludes edge No. 9 from movement candidate edges.

Also, edge No. 24 is included in the security information list identified by intruder agent C1. Accordingly, the simulation execution unit 16 excludes edge No. 24 from movement candidate edges. Thereby, the simulation execution unit 16 determines remaining edge No. 17 as the next movement destination.

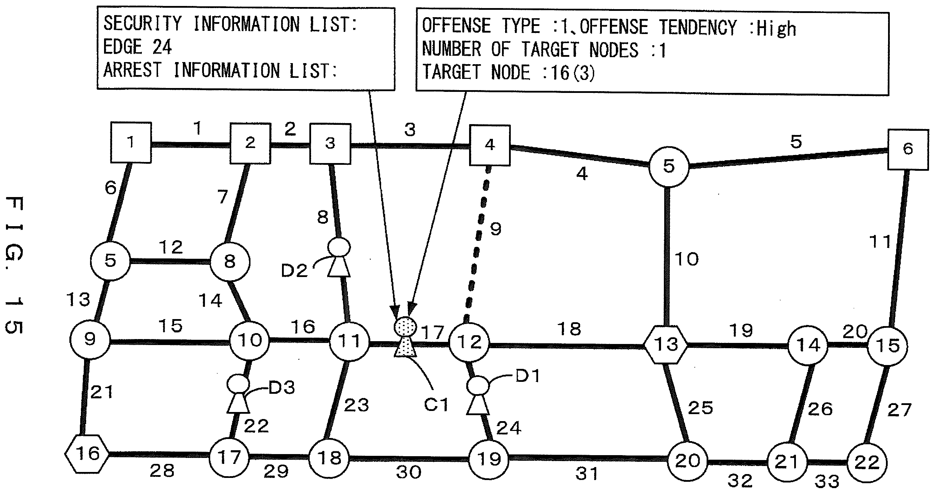

FIG. 15 illustrates an example of a situation where intruder agent C1 is staying on edge No. 17. When the movement number of steps of edge No. 17 is 18, intruder agent C1 stays on edge No. 17 while the number of steps is from 23 through 39.

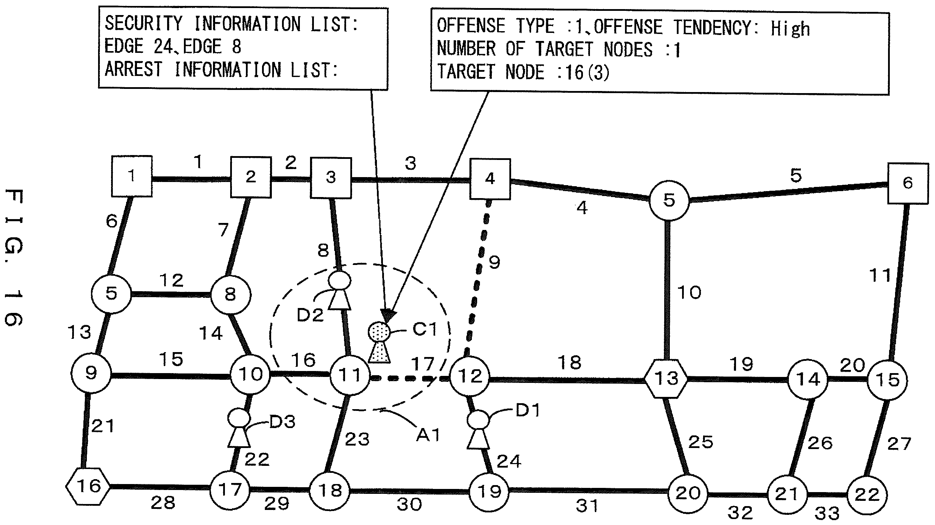

When the number of steps becomes 40, the simulation execution unit 16 moves the intruder agent C1 to edge No. 17. As illustrated in the example of FIG. 16, the display control unit 18 displays the movement route of intruder agent C1 (edge No. 17) in a manner different from those of other edges.

The simulation execution unit 16 determines whether or not a security guard is included in the identification scope of intruder agent C1 located in node No. 11. In the example illustrated in FIG. 16, it is assumed that security guard D2 is included in the identification scope of intruder agent C1. In such a case, the simulation execution unit 16 adds edge 8 to the security information list. Then, the simulation execution unit 16 selects the next movement route of intruder agent C1.

The movement candidate edges are the edges of numbers 8, 16, 17 and 23. Because intruder agent C1 has identified security guard D2 in edge No. 8, edge No. 8 is excluded from the movement candidate edges. Also, because edge No. 18 is the edge that the intruder agent passed through immediately before, it is excluded from movement candidate edges.

Accordingly, the simulation execution unit 16 selects one of edges No. 16 and No. 23 as a movement route (edge). In the example, it is assumed that the evaluation value of the edge No. 23 computed by the simulation execution unit 16 by using the above formula is lower than that of edge No. 16. Accordingly, the simulation execution unit 16 moves intruder agent C1 to edge No. 16.

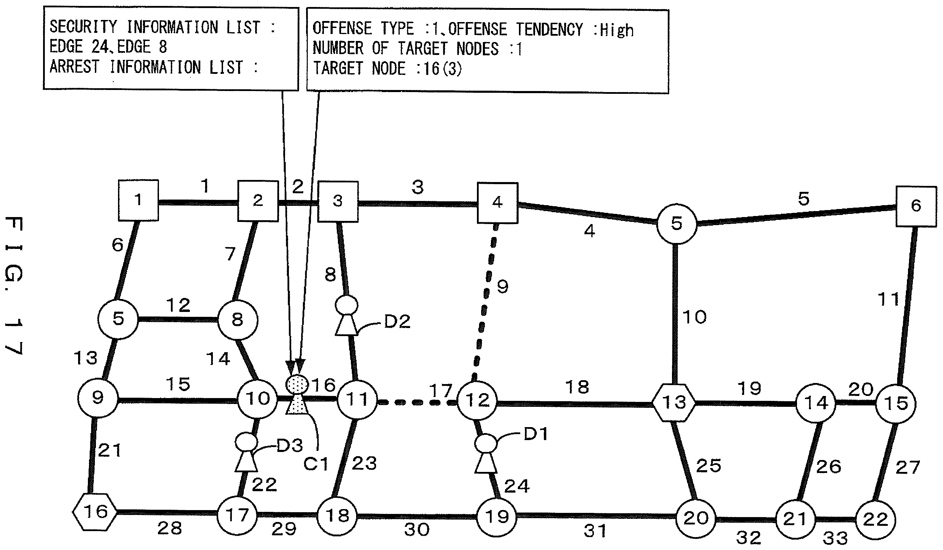

FIG. 17 illustrates a state in which the simulation execution unit 16 has moved intruder agent C1 to edge No. 16. It is assumed that the movement number of steps of edge No. 16 is 4. Accordingly, the simulation execution unit 16 makes intruder agent C1 stay in edge No. 16 while the number of steps is in a range between 41 and 45.

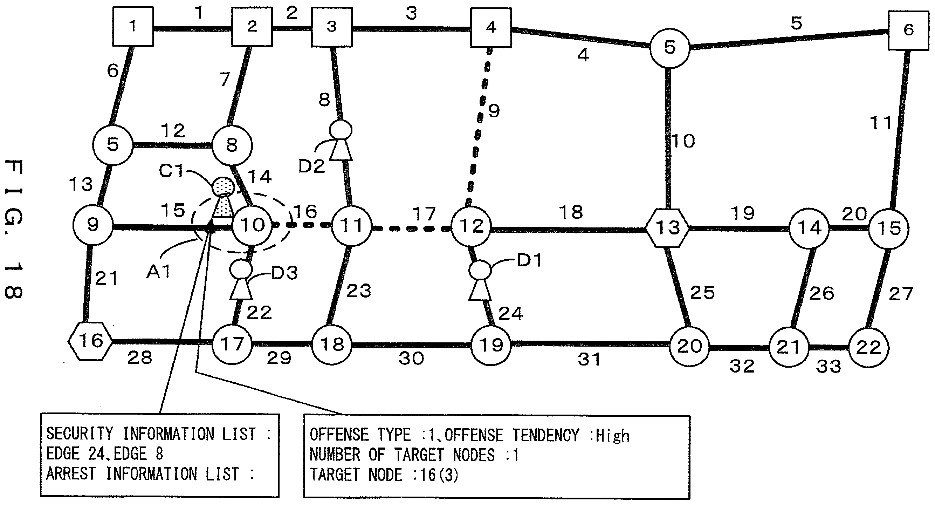

When the number of steps is 46, the simulation execution unit 16 moves intruder agent C1 to node No. 10. As illustrated in the example of FIG. 18, the display control unit 18 displays the movement route (edge No. 16) of intruder agent C1 in a manner different from those of other edges.

When intruder agent C1 is in node No. 10, the movement candidate edges for intruder agent C1 are the edges of numbers 14 , 15 , 16 and 22. From among them, edge No. 16 that the intruder agent passed immediately before is excluded.

As illustrated in the example of FIG. 18, security guard D3 has been deployed to edge No. 22. However, it is assumed in the example of FIG. 18 that security guard D3 is not included in the identification scope of node No. 10. Accordingly, because intruder agent C1 does not identify security guard D3, the simulation execution unit 16 does not exclude edge No. 22 from the movement candidate edges.

Accordingly, the movement candidate edges for intruder agent C1 are the edges of numbers 14, 15 and 22. It is assumed that edge No. 22 has the lowest evaluation value from among these movement candidate edges. Accordingly, the simulation execution unit 16 moves intruder agent C1 to edge No. 22.

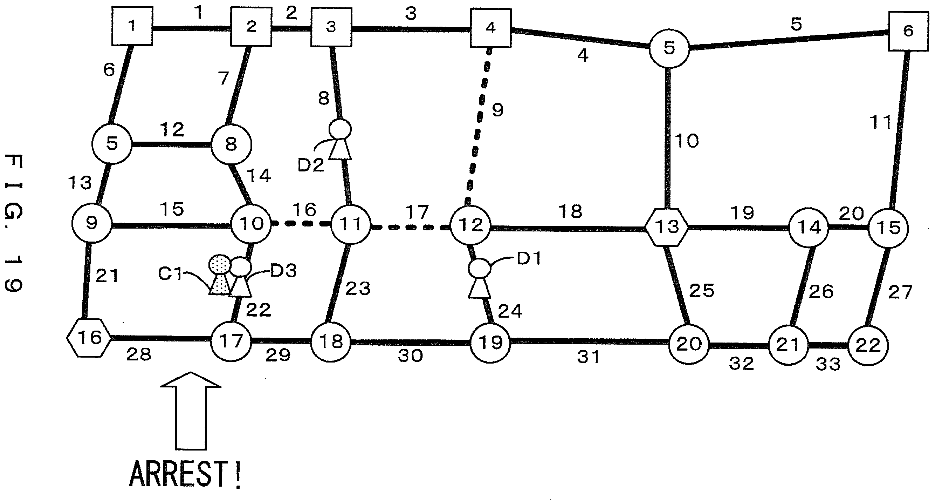

In the example of FIG. 19, security guard D3 has been deployed to edge No. 22. In a case when the security method of security guard D3 matches the offense type of intruder agent C1, because intruder agent C1 and security guard D3 have encountered each other, intruder agent C1 is arrested by security guard D3. This means the security plan has been successful in this case.

In response to intruder agent C1 encountering security guard D3, the display control unit 18 displays information indicating the arrest in the display device 3. This makes it possible to visualize the fact that intruder agent C1 has encountered security guard D3 and been arrested. The display control unit 18 can display the result of a simulation with a high visibility by displaying an alert of "arrest!".

The simulation execution unit 16 identifies a movement route so that intruder agent C1 avoids encountering security guards D1 through D3. Also, the display control unit 18 displays, in the display device 3, the movement route of intruder agent C1 identified by the simulation execution unit 16, together with the deployment positions of security guards D1 through D3.

In accordance with the deployment positions of security guards D1 through D3, the user monitoring the simulation window can identify what type of movements intruder agent C1 will select. In other words, the display of the movement route is a result of dynamic temporal changes in the positions of intruder agent C1.

Intruder agent C1 at that moment identifies the movement route so as to avoid security guards D1 through D3 as described above, and thus is based on the actual conditions. This makes it possible to evaluate a security plan objectively.

Also, as illustrated in FIG. 19, the display control unit 18 displays, in the display device 3, not only an alert indicating the arrest of intruder agent C1 but also the movement route when the intruder agent was arrested. Thereby, the user can identify the result of the simulation and the movement route of intruder agent C1 so as to evaluate the security plan objectively.

Also, as illustrated in FIG. 10 through FIG. 18, the display control unit 18 displays identification information in the display device 3 in accordance with the movement of intruder agent C1. This makes it possible for the user to identify the content of the identification information when the simulation execution unit 16 selects the route of intruder agent C1.

Also, the display control unit 18 displays changes in identification information in accordance with the movement of intruder agent C1. This makes it possible for the user to identify, on the basis of the changes in identification information, how the simulation execution unit 16 changed the route selection of intruder agent C1.

Also, the display control unit 18 displays, in the display device 3, an area representing identification scope A1 in accordance with the position of intruder agent C1. This makes it possible for the user to identify identification scope A1 in accordance with the position of intruder agent C1.

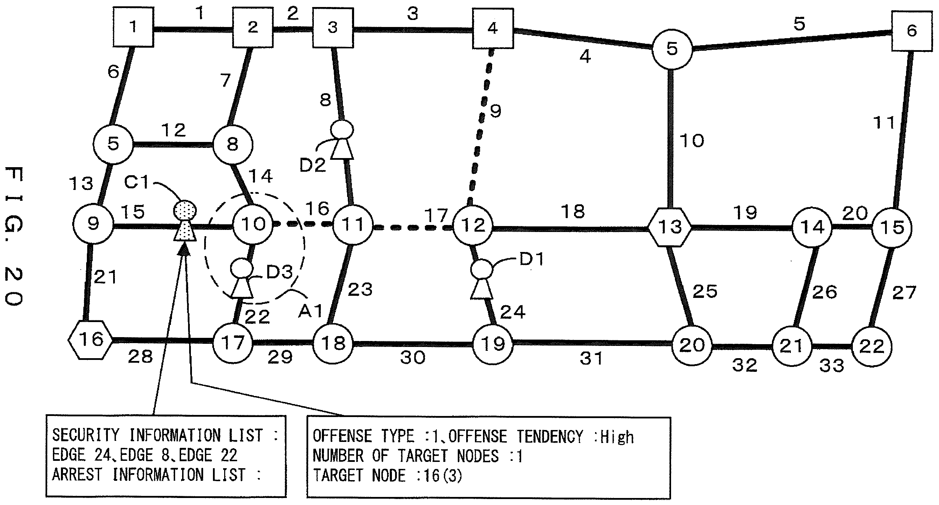

FIG. 20 illustrates an example in which security guard D3 is included in identification scope A1 of node No. 10 in the example of FIG. 18. In such a case, the simulation execution unit 16 adds edge No. 22 to the security information list as illustrated in FIG. 20. The movement candidate edges are the edges of numbers 14 and 15.

The simulation execution unit 16 computes the evaluation value. It is assumed that edge No. 15 has the lower evaluation value. Thus, the simulation execution unit 16 moves intruder agent C1 to edge No. 15.

Accordingly, when intruder agent C1 identifies security guard D3 in node No. 10, the simulation execution unit 16 makes intruder agent C1 select a route that avoids security guard D3. In such a case, intruder agent C1 passes through edge No. 21 from node No. 9 so as to reach the target node of number 16.

Accordingly, intruder agent C1 may be arrested or may reach target node No. 16 so as to achieve the goal, depending upon whether or not security guard D3 is included in the identification scope of node No. 10,

### <Second specific example>

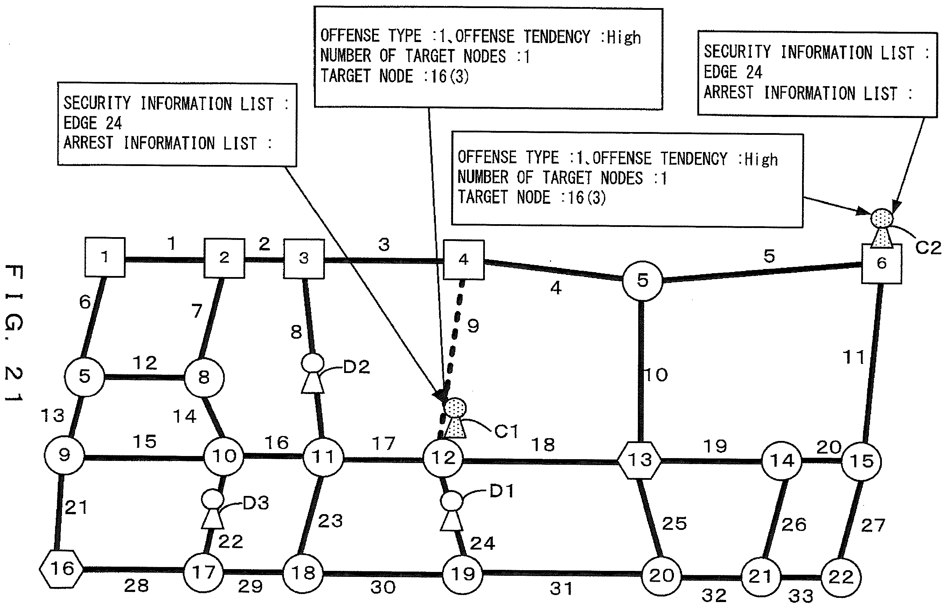

Next, by referring to FIG. 21 through FIG. 27, a second specific example will be explained. It is assumed in the second specific example that when the number of steps is 20, intruder agent C1 is located in node No. 12. It is also assumed that when the number of steps is 20, intruder agent C2 that is different from intruder agent C1 is generated.

It is assumed that intruder agent C2 has attribute information of "1" as the offense type, "High" as the offense tendency, "1" as the number of target nodes, and a target node of number 16, similarly to intruder agent C1. The intruder agents C1 and C2 may have different pieces of attribute information.

In the example illustrated in FIG. 21, intruder agent C2 is generated in node No. 6. The security information list of intruder agent C1 includes edge No. 24. Accordingly, the simulation execution unit 16 adds edge No. 24 to the security information list of intruder agent C2 generated by the intruder generation control unit 15. In other words, at the moment when intruder agent C2 is generated, the security information list of intruder agent C2 includes edge No. 24.

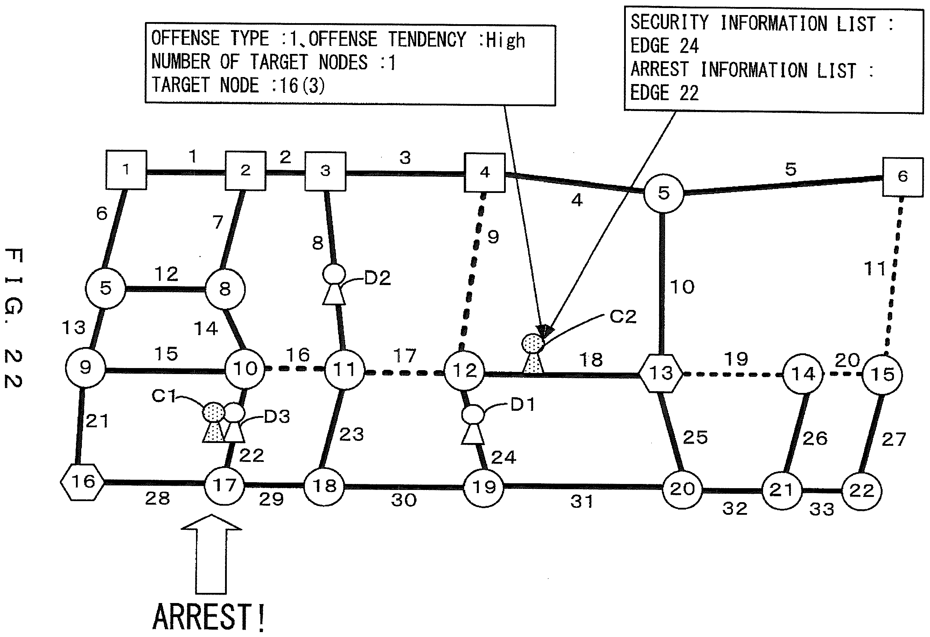

FIG. 22 illustrates an example in which intruder agent C1 and security guard D3 have encountered each other and intruder agent C1 has been arrested by security guard D3. It is assumed that the number of steps at that moment is 46. It is assumed that intruder agent C2, generated in node No. 6, is in node No. 18 at the moment when the number of steps is 46 after passing through edges No. 11, No. 15, No. 14 and No. 13.

In the example illustrated in FIG. 22, the display control unit 18 may display the movement routes of intruder agents C1 and C2 in respective different ways. In the example illustrated in FIG. 22, the movement routes of intruder agents C1 and C2 are represented by lines with different thicknesses in the display device 3.

When the number of steps is 46, intruder agent C1 has been arrested by security guard D3. Accordingly, the simulation execution unit 16 adds edge No. 22 of the time when intruder agent C1 was arrested to the arrest information list of the intruder agent C2.

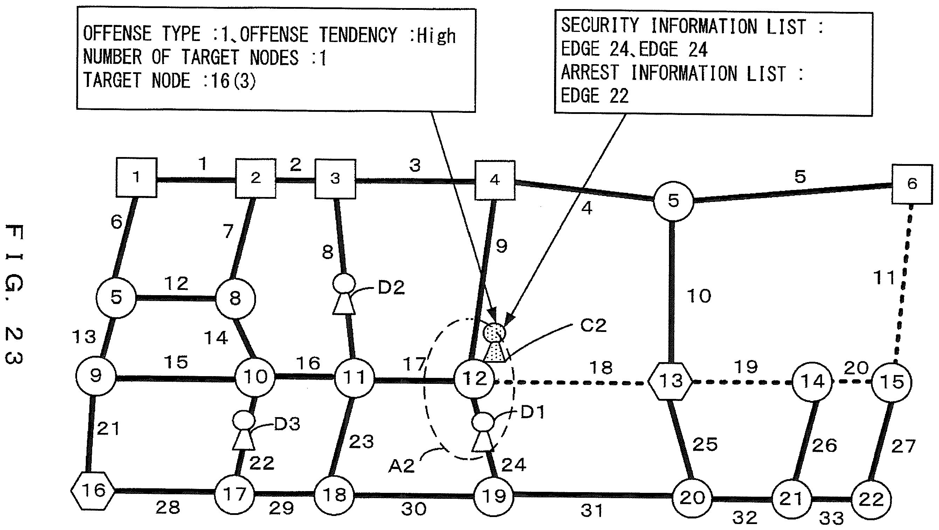

FIG. 23 illustrates an example in which intruder agent C1 is located in node No. 12. It is assumed that the number of steps at that moment is 50. When the number of steps is 50, intruder agent C1 has been arrested. Accordingly, intruder agent C1 has disappeared from the simulation window.

As illustrated in the example of FIG. 23, identification scope A2 of node No. 12 includes security guard D1. Accordingly, intruder agent C2 identifies security guard D1. The simulation execution unit 16 adds edge No. 24 to the security information list of intruder agent C2.

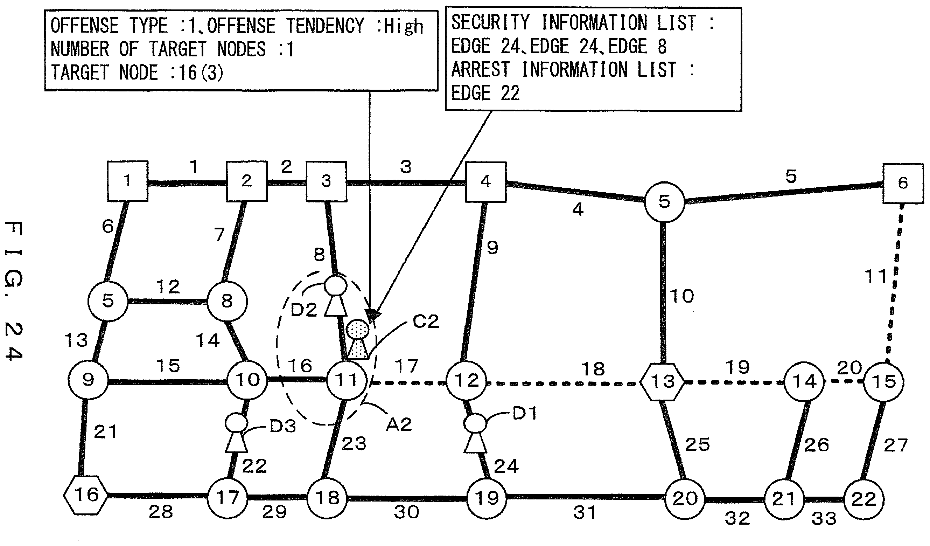

FIG. 24 illustrates an example in which intruder agent C2 is located in node No. 11. It is assumed that the number of steps is 60 at that moment. The identification scope of node No. 11 includes security guard D2. Accordingly, intruder agent C2 identifies security guard D2. The simulation execution unit 16 adds edge No. 8 to the security information list of intruder agent C2.

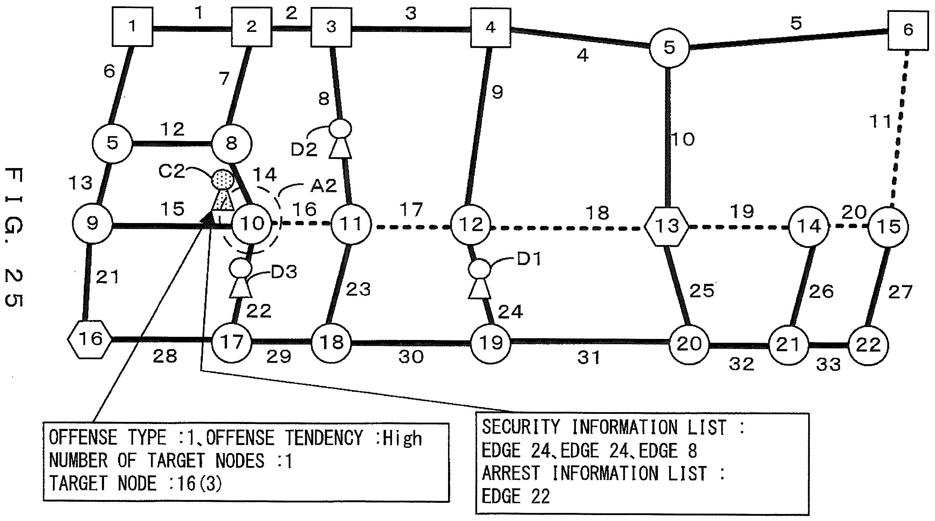

FIG. 25 illustrates an example in which intruder agent C2 is located in node No. 10. It is assumed that the number of steps is 74 at that moment. Identification scope A2 of node No. 10 does not include security guard D3. Accordingly, intruder agent C2 does not identify security guard D3.

Meanwhile, arrest information list of intruder agent C2 includes edge No. 22. Accordingly, even when intruder agent C2 does not identify security guard D3 , the simulation execution unit 16 excludes edge No. 22 from the movement candidate edges.

The simulation execution unit 16 selects the edge with the lower evaluation value between edge No. 14 and edge No. 15. It is assumed in the example of FIG. 25 that edge No. 15 has the lower evaluation value. Accordingly, the simulation execution unit 16 moves intruder agent C2 to edge No. 15.

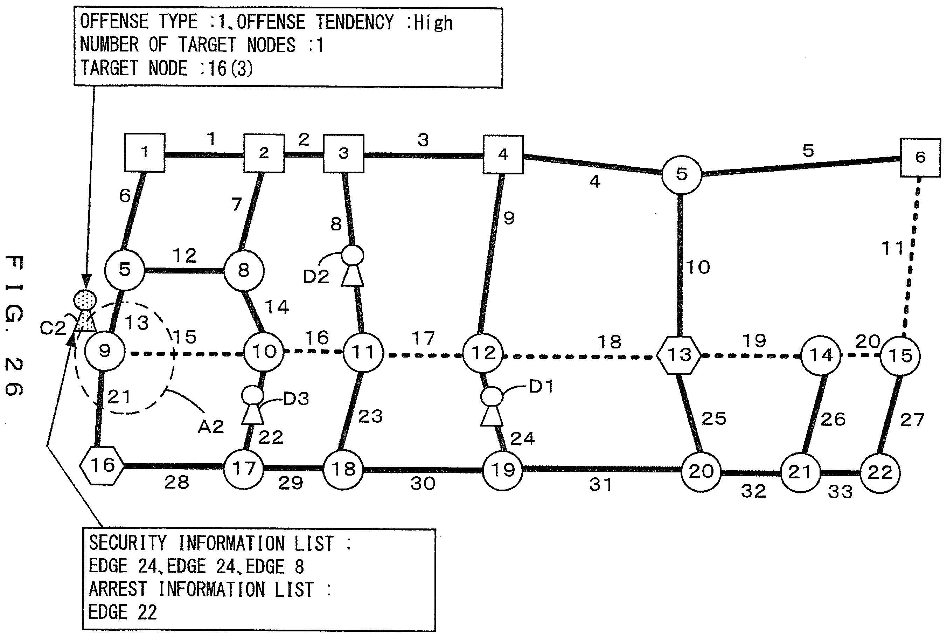

FIG. 26 illustrates an example in which intruder agent C2 is located in node No. 9. It is assumed that the number of steps is 75 at that moment. The simulation execution unit 16 selects the edge with the lower evaluation value between edge No. 13 and edge No. 21. Edge No. 21 is connected to target node No. 16, and thus has a low evaluation value.

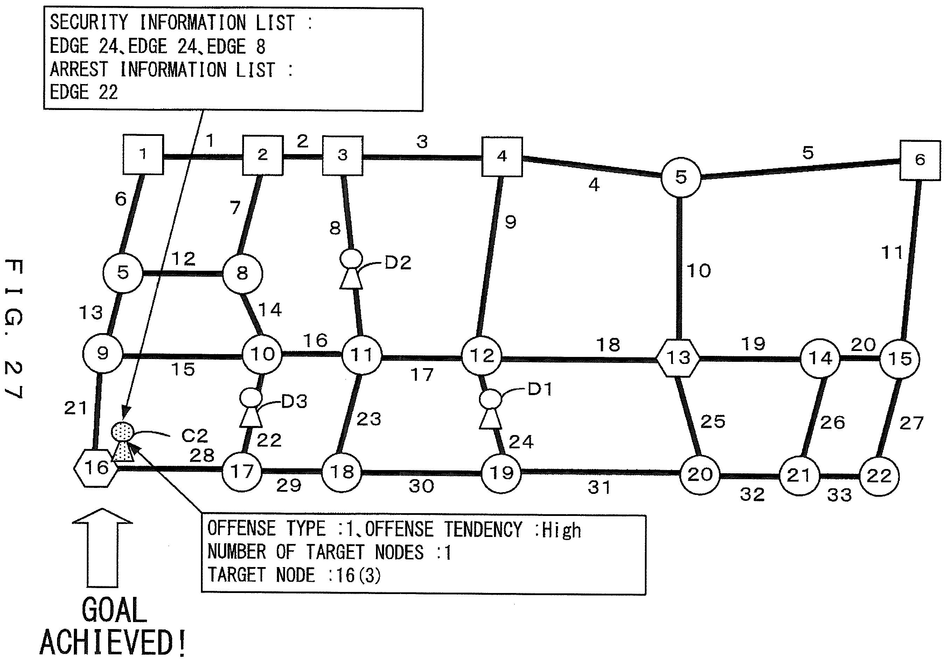

Accordingly, the simulation execution unit 16 moves intruder agent C2 to edge No. 21. Then, as illustrated in the example of FIG. 27, intruder agent C2 reaches target node No. 16. It is assumed that the number of steps is 75 at that moment.

Accordingly, because intruder agent C2 reached target node No. 16 with 75 steps, intruder agent C2 achieves a goal. The display control unit 18 displays an alert of "goal achieved!" in the display device 3 because intruder agent C2 reached a target point or zone. This means the security plan was a failure in this case.

### <Third specific example>

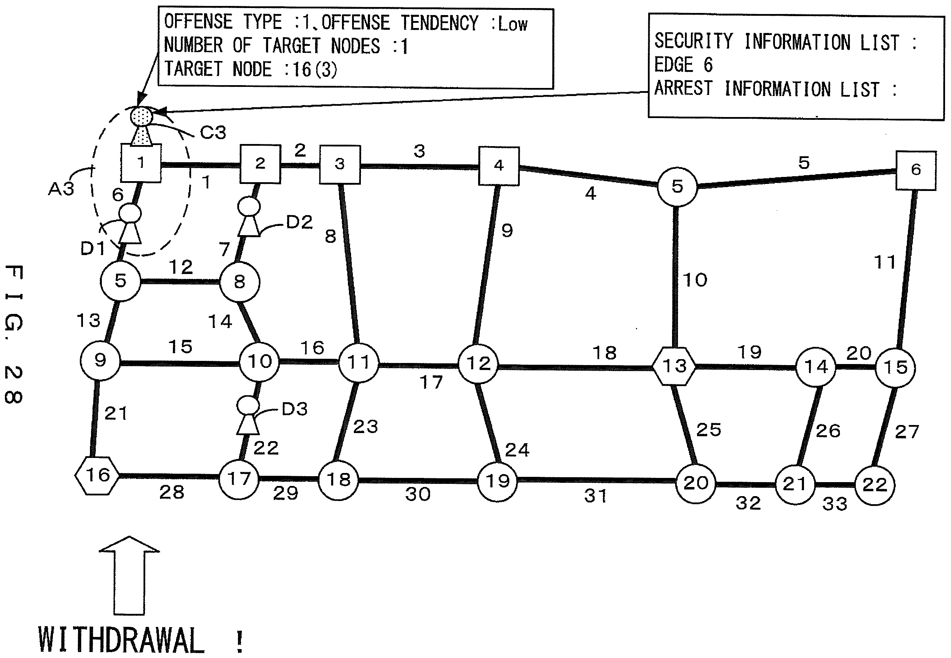

Explanations will be given for a third specific example by referring to the examples of FIG. 28 through FIG. 30. The third specific example illustrates a case when the simulation execution unit 16 withdraws intruder agent C3.

In the example of FIG. 28, the intruder generation control unit 15 has generated intruder agent C3 in node No. 1. The offense tendency of intruder agent C3 is Low. This means that intruder agent C3 tends to avoid risks.

In the example illustrated in FIG. 28, security guard D1 has been deployed to edge No. 6, which is connected to node No. 1. It is assumed that identification scope A3 of node No. 1 includes security guard D1. In such a case, intruder agent C3 identifies security guard c1. The simulation execution unit 16 adds edge No. 6 to the security information list of intruder agent C3.

The movement candidate edges of intruder agent C3 are the edges of numbers 1 and 6. As described above, the security information list of intruder agent C3 includes number 6, and thus the simulation execution unit 16 selects edge No. 1 as the next movement destination.

The simulation execution unit 16 computes the evaluation value of the shortest route that passes through edge No. 1. Because the offense tendency of intruder agent C1 is Low, the withdrawal threshold is low. It is assumed for example that the withdrawal threshold of intruder agent C3 is roughly identical to the number of movement steps of the route that passes through edges No. 6, No. 13 and No. 21.

In such a case, the evaluation value of the shortest route in a case when intruder agent C3 passes through edge No. 1 is higher than the withdrawal threshold. Accordingly, the simulation execution unit 16 withdraws intruder agent C3. Accordingly, the simulation execution unit 16 makes intruder agent C3 disappear.

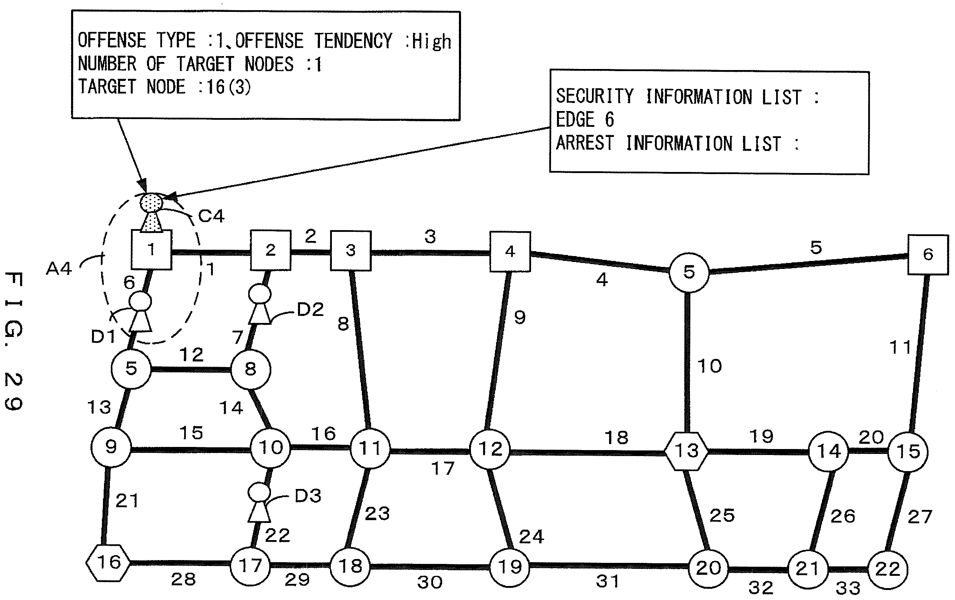

FIG. 29 illustrates an example in which the tendency in the attribute information of intruder agent C4 generated in node No. 1 is High. Identification scope A4 of edge No. 6 includes security guard D1. Accordingly, the simulation execution unit 16 adds edge No. 6 to the security information list. The movement candidate edge for intruder agent C4 deployed in edge No. 6 is the edge of number 1.

The simulation execution unit 16 evaluates the shortest route that is connected to target node No. 16 via edge No. 1. The tendency of intruder agent C4 is High in the example illustrated in FIG. 29. Because the tendency of intruder agent C4 is High, the simulation execution unit 16 determines that the evaluation value of the shortest route that passes through edge No. 1 is equal to or smaller than the withdrawal threshold.

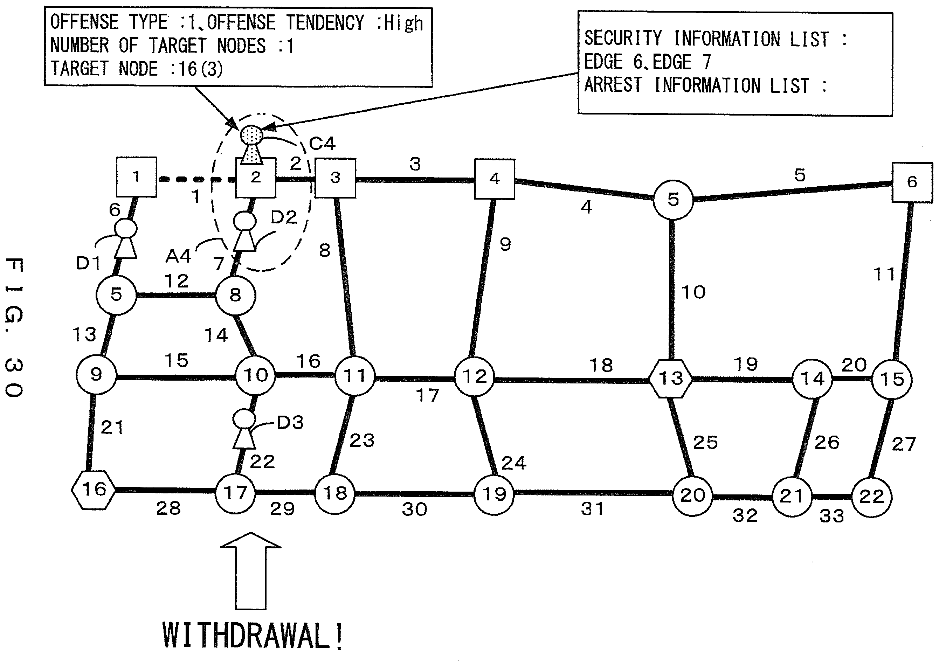

Accordingly, the intruder agent C4 passes through edge No. 1 so as to reach node No. 2. FIG. 30 illustrates an example in which intruder agent C4 is located in node No. 2. It is assumed that identification scope A4 of node No. 2 includes security guard D2. In such a case, the simulation execution unit 16 adds edge No. 7 to the security information list of intruder agent C4.

The simulation execution unit 16 determines that the movement candidate edge is the edge of number 2. The simulation execution unit 16 assumes that the evaluation value of the route with the lowest evaluation value from among the routes connected to target node No. 16 via edge No. 2 has exceeded the withdrawal threshold.

In such a case, the simulation execution unit 16 determines to withdraw intruder agent C4 because the lowest evaluation value of the route has exceeded the withdrawal threshold even though the tendency in the attribute information of intruder agent C4 is High. Accordingly, the simulation execution unit 16 makes intruder agent C4 disappear. Then, the display control unit 18 displays an alert of "withdrawal!" in the display device 3.

### <Example of numerical evaluation>

The simulation execution unit 16 executes a simulation of moving an intruder agent on the basis of a security plan created in advance. The result output unit 19 stores, in the execution result storage unit 20, the result of the execution of the simulation by the simulation execution unit 16. The simulation execution unit 16 outputs the execution result to the display control unit 18.

A security plan includes information of a security guard that is deployed in a model. The simulation execution unit 16 repeatedly executes a simulation for one security plan. The result output unit 19 collects simulation results so as to output the collected results to the display control unit 18, and the display control unit 18 displays the collected results in the display device 3.

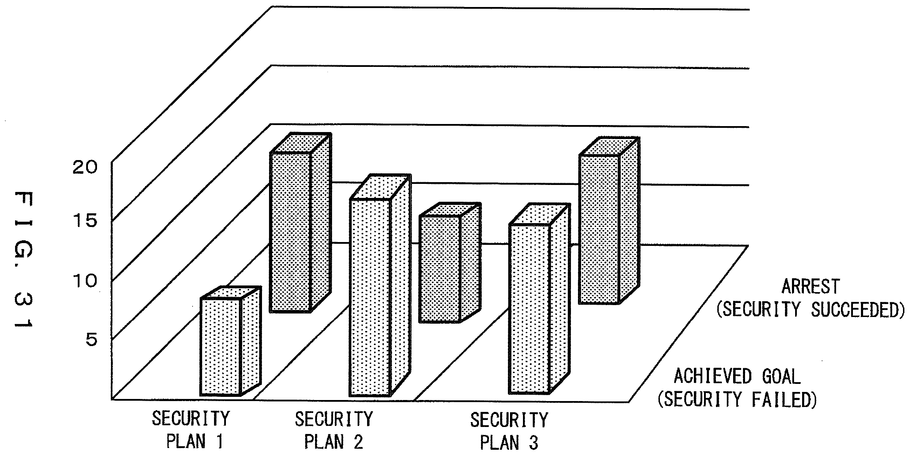

FIG. 31 illustrates an example of collected results displayed in the display device 3. For example, in the example illustrated in FIG. 31, the simulation execution unit 16 displays, in the display device 3, the number of arrests and the number of achieved goals, which are the results of the execution of a simulation by the simulation execution unit 16, on the basis of the deployment of security guards based on security plan 1.

In the case of the example illustrated in FIG. 31, the user can objectively evaluate that security plan 1 is effective on the basis of the display in the display device 3 because security plan 1 has resulted in a number of arrests that is greater than a number of achieved goals.

Also, in the case illustrated in FIG. 31, the user can objectively evaluate that security plan 2 is not effective on the basis of the display of the display device 3 because security plan 2 has resulted in a number of achieved goals that is greater than a number of arrests.

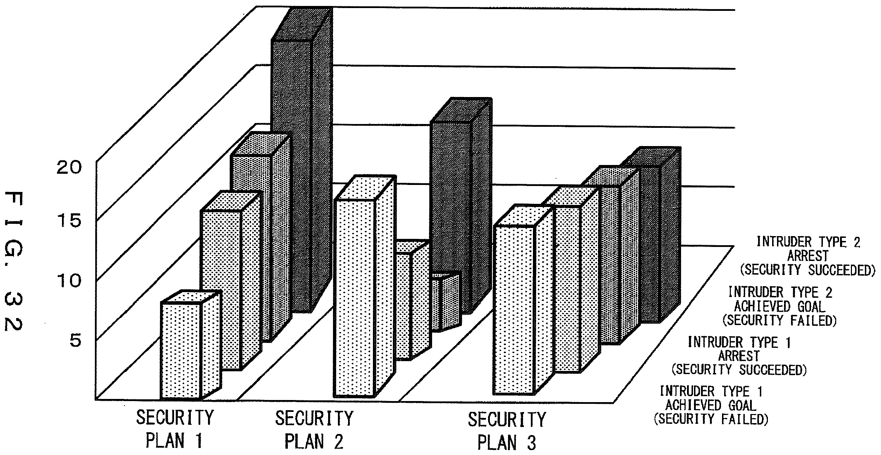

FIG. 32 illustrates a display example of a collection result for each intruder type. An intruder type means an offense type described above. In the case of security plan 1, both intruder types 1 and 2 have numbers of arrests that are greater than the numbers of achieved goals, making it possible for the user to objectively evaluate that security plan 1 is effective on the basis of the display in the display device 3.

Security plan 2 resulted in a number of arrests that is greater than the number of achieved goals for intruder type 1. Meanwhile, intruder type 2 has a number of arrests that is greater than the number of achieved goals. This makes it possible for the user to identify, on the basis of the display of the display device 3, that security plan 2 is not effective against intruder type 1 while it is effective against intruder type 2.

While the examples illustrated in FIG. 31 and FIG. 32 illustrate the number of achieved goals and the number of arrests under a security plan (for a deployment pattern of security guards), the display control unit 18 may display collection results of other parameters in the display device 3. For example, the display control unit 18 may display the number of withdrawals in the display device 3.

Also, the display control unit 18 may display either the number of achieved goals or the number of arrests alone. Also, the display control unit 18 may display collection results for each tendency or target node of intruders or for each node or edge to which an intruder agent moved.

Also, in the examples illustrated in FIG. 31 and FIG. 32, the display device 3 displays values of the respective security plans in a form of a bar chart. However, the display device 3 may display values in a form other than a bar chart. For example, the values may be expressed in a form of a table.

### <Example of hardware configuration of simulation apparatus>

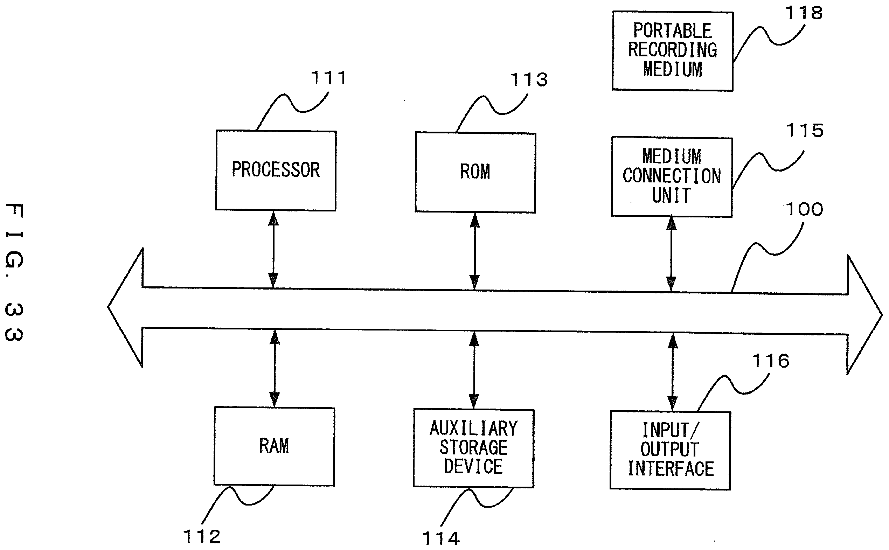

Next, explanations will be given for an example of a hardware configuration of the simulation apparatus by referring to Fig. 33. As illustrated in the example of Fig. 33, a processor 111, a Random Access Memory (RAM) 112, a Read Only Memory (ROM) 113, an auxiliary storage device 114, a medium connection unit 115, and an input/output interface 116 are connected to a bus 100.

The processor 111 is an arbitrary processing circuit such as a Central Processing Unit (CPU). The processor 111 executes a program developed in the RAM 112. The simulation program according to the embodiment can be applied as a program to be executed. The ROM 113 is a non-volatile storage device that stores a program developed in the RAM 112.

The auxiliary storage device 114 is a storage device that stores various types of pieces of information, and a hard disk drive, a semiconductor memory, etc. for example can be applied as the auxiliary storage device 114. The medium connection unit 115 is provided in such a manner that it can be connected to a portable recording medium 118.

A portable memory or an optical disk (for example, a Compact Disk (CD), a Digital Versatile Disk (DVD), etc.) can be applied as the portable recording medium 118. The simulation program according to the embodiment can be recorded in this portable recording medium 118.

The input/output interface 116 is connected to for example the input device 2 and the display device 3. The input information storage unit 12, the history information storage unit 17 and the execution result storage unit 20 of the simulation apparatus 1 may be implemented by the RAM 112 or the auxiliary storage device 114.

The respective units other than the input information storage unit 12, the history information storage unit 17 and the execution result storage unit 20 in the simulation apparatus 1 may be implemented by the processor 111. The RAM 112, the ROM 113 and the auxiliary storage device 114 are examples of a computer-readable tangible storage medium. These tangible storage mediums are not a transitory like a signal carrier wave.

### <Others>

While the embodiment of the disclosure and advantages thereof have been described in detail, those skilled in the art will understand that various changes, additions and omissions are possible without departing from the scope of the present invention, which is clearly described in the claims.

### [Symbols]

- 1: SIMULATION APPARATUS
- 2: INPUT DEVICE
- 3: DISPLAY DEVICE
- 11: INFORMATION RECEPTION UNIT
- 12: INPUT INFORMATION STORAGE UNIT
- 13: MODEL GENERATION UNIT
- 14: SECURITY GUARD DEPLOYMENT CONTROL UNIT
- 15: INTRUDER GENERATION CONTROL UNIT
- 16: SIMULATION EXECUTION UNIT
- 17: HISTORY INFORMATION STORAGE UNIT
- 18: DISPLAY CONTROL UNIT
- 19: RESULT OUTPUT UNIT
- 20: EXECUTION RESULT STORAGE UNIT

## Claims

1. A simulation method for simulating by using a computer a movement of an intruder that has entered a security zone, the simulation method comprising:
generating a model of a movement route by referring to a storage unit that stores information related to a movement route included in the security zone;
receiving input of a position to which a security guard is deployed from among positions in the model of the movement route;
generating an agent of an intruder at one of the positions in the model of the movement route; and
forming a movement route of the agent of the intruder in accordance with the position of the security guard in a case when the security guard is included in an identification scope, in which the agent of the intruder identifies the security guard, when a movement of the generated agent of the intruder is simulated.

2. The simulation method according to claim 1, wherein
a movement route of the agent of the intruder is formed so that a selection probability that an avoidance route of avoiding a position of a security guard included in the identification scope will be selected increases.

3. The simulation method according to claim 1 or 2, wherein
a movement route of the agent of the intruder is further formed on the basis of a length of each of the movement routes from a position of the generated agent of the intruder to a prescribed point or zone.

4. The simulation method according to one of claims 1 through 3, wherein
by referring to a storage unit storing information including a position at which an intruder was arrested in the past, a movement route of the generated agent of the intruder is further formed on the basis of the position of the arrest.

5. The simulation method according to claim 4, wherein
a movement route of the agent of the intruder is formed so that a selection probability that a route of avoiding the position of the arrest will be selected increases.

6. The simulation method according to one of claims 1 through 5, wherein
the identification scope is changed in accordance with a movement of the agent of the intruder.

7. The simulation method according to one of claims 1 through 6, wherein
the agent of the intruder is withdrawn when a value based on a length of the movement route and a tendency of the agent of the intruder becomes equal to or greater than a prescribed value.

8. The simulation method according to one of claims 1 through 7, wherein
when the security guard and the agent of the intruder that respectively have a security method and an offense type that do not match each other encounter each other, the security guard does not arrest the agent of the intruder.

9. A simulation method conducted by a computer, the simulation method comprising:
simulating a movement route of an intruder in accordance with a deployment position of one or a plurality of security guards in a security zone;
identifying, when a plurality of movement routes are formed in accordance with the simulation, a movement route by which the intruder avoids an encounter with the security guard so as to reach a prescribed point or zone or a movement route by which the intruder encounters the security guard, from among the plurality of movement routes; and
displaying the identified movement route including a deployment position or a change after deployment of the one or a plurality of security guards.

10. The simulation method according to claim 9, wherein
a display of the movement route is a dynamic display of a temporal change of a position of the intruder.

11. The simulation method according to claim 10, wherein
when the intruder encounters the security guard, information indicating the encounter with the security guard is displayed, and when the intruder reaches the prescribed point or zone, information indicating that the prescribed point or zone was reached is displayed.

12. The simulation method according to claim 9, wherein
for a movement route by which the intruder avoided the encounter with the security guard to reach the prescribed point or zone, a fact that the prescribed point or zone was reached is identified and displayed, and for a movement route by which the intruder encountered the security guard, a fact that the intruder encountered the security guard is identified and displayed.

13. The simulation method according to one of claims 9 through 12, wherein
when movement routes of a plurality of intruders are simulated for each deployment position of the one or a plurality of security guards, at least one of the number of the intruders that have encountered the security guard and the number of the intruders that have reached the prescribed point or zone is displayed from among the plurality of intruders.

14. The simulation method according to one of claims 9 through 13, wherein
identification information in accordance with an identification scope in which the intruder identifies the security guard is displayed in accordance with a movement of the intruder.

15. The simulation method according to one of claims 9 through 13, wherein
a change in identification information in accordance with an identification scope in which the intruder identifies the security guard is displayed in accordance with a movement of the intruder.

16. The simulation method according to one of claims 9 through 13, wherein
an area representing an identification scope in which the security guard identifies the intruder is displayed.

17. The simulation method according to one of claims 9 through 16, wherein
the agent of the intruder is withdrawn and the withdrawal is displayed when a value based on a length of the movement route and a tendency of the agent of the intruder becomes equal to or greater than a prescribed value.

18. A simulation program, for simulating a movement of an intruder that has entered a security zone, that causes the computer to execute a process comprising:
generating a model of a movement route by referring to a storage unit that stores information related to a movement route included in the security zone;
receiving input of a position at which a security guard is deployed from among positions in the model of the movement route;
generating an agent of an intruder at one of the positions in the model of the movement route; and
forming a movement route of the agent of the intruder in accordance with the position of the security guard in a case when the security guard is included in an identification scope, in which the agent of the intruder identifies the security guard, when a movement of the generated agent of the intruder is simulated.

19. A simulation program that causes a computer to execute a process comprising:
executing a simulation of forming a movement route of an intruder in accordance with a deployment position of one or a plurality of security guards in a security zone;
identifying, when a plurality of movement routes are formed in accordance with the simulation, a movement route by which the intruder avoids an encounter with the security guard so as to reach a prescribed point or zone or a movement route by which the intruder encounters the security guard, from among the plurality of movement routes; and
displaying the identified movement route including a deployment position or a change after deployment of the one or a plurality of security guards.

20. A simulation apparatus for simulating, by using a computer, a movement of an intruder that has entered a security zone, the apparatus comprising:
a storage unit that stores information related to a movement route included in the security zone;
a model generation unit that generates a model of a movement route by referring to the storage unit;
an information reception unit that receives an input of a position at which a security guard is deployed from among the positions in the model of the movement route;
an agent generation unit that generates an agent of an intruder at one of the positions in the model of the movement route; and
a simulation execution unit that forms a movement route of the agent of the intruder in accordance with the position of the security guard in a case when the security guard is included in an identification scope, in which the agent of the intruder identifies the security guard, when a movement of the generated agent of the intruder is simulated.

21. A simulation apparatus comprising:
a simulation execution unit that executes a simulation of forming a movement route of an intruder in accordance with a deployment position of one or a plurality of security guards in a security zone, and identifies, when a plurality of movement routes are formed in accordance with the simulation, a movement route by which the intruder avoids an encounter with the security guard so as to reach a prescribed point or zone or a movement route by which the intruder encounters the security guard, from among the plurality of movement routes; and
a display unit that displays the identified movement route including a deployment position or a change after deployment of the one or a plurality of security guards.
